# EUROPEAN PATENT SPECIFICATION

(11) **EP 1 417 712 B1**
(45) Date of publication and mention of the grant of the patent: **15.11.2006**
(21) Application number: 02749717.1
(22) Date of filing: 28.06.2002
(51) Int. Cl.: H01L 27/15, H01L 31/12, H01L 33/00

(54) **INTEGRATED ARRAYS OF MODULATORS AND LASERS ON ELECTRONICS**
INTEGRIERTE ARRAYS VON MODULATOREN UND LASERN AUF EINER ELEKTRONISCHEN SCHALTUNG
RESEAUX INTEGRES DE MODULATEURS ET DE LASERS SUR CIRCUIT ELECTRONIQUE

(30) Priority: 29.06.2001 US 896189; 29.06.2001 US 896665; 29.06.2001 US 897160; 29.06.2001 US 896983; 29.06.2001 US 897158; 19.03.2002 US 365998 P; 19.03.2002 US 366032 P; 26.06.2002 US 180610
(43) Date of publication of application: 12.05.2004
(73) Proprietor: Xanoptix, Inc., Merrimack, NH 03054 (US)
(72) Inventor: TREZZA, John, Nashua, NH 03063 (US)
(74) Representative: Walaski, Jan Filip
(86) International application number: PCT/US2002/020696
(87) International publication number: WO 2003/003465

(56) References cited:
- EP-A- 0 760 544
- US-A- 6 022 760
- US-B1- 6 184 066
- PU R ET AL: "THERMAL RESISTANCE OF VCSEL'S BONDED TO INTEGRATED CIRCUITS" IEEE PHOTONICS TECHNOLOGY LETTERS, IEEE INC. NEW YORK, US, vol. 11, no. 12, December 1999 (1999-12), pages 1554-1556, XP000924494 ISSN: 1041-1135

## Description

This invention relates to optical devices and, more particularly, to optical devices involving lasers and modulators.

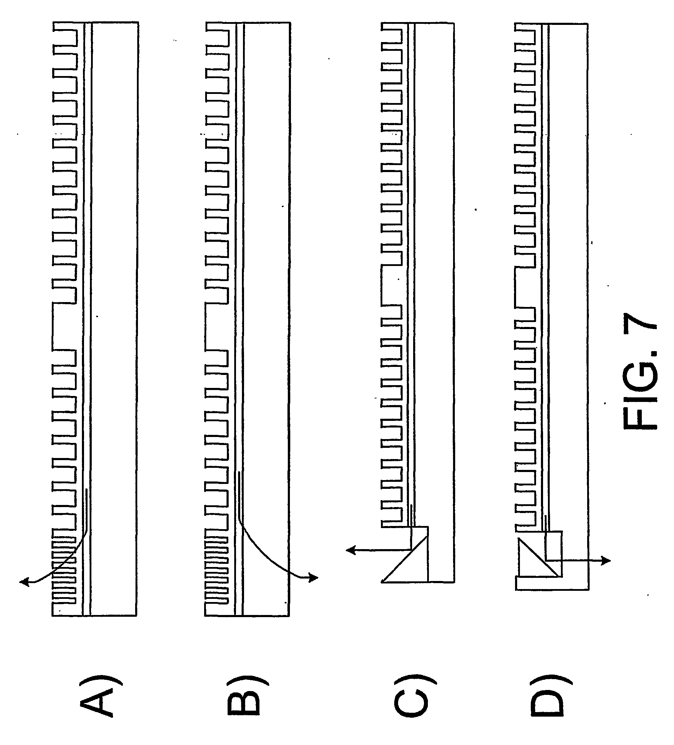

As set forth herein, items in the figures are designated in the form #₁-#₂ where #₁ indicates the relevant figure and #₂ indicates the item in that figure. For example, a reference to 7-218 means item 218 in Fig. 7.

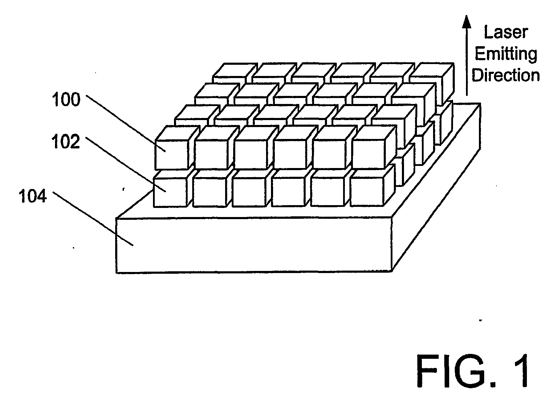

External modulation has been used in some semiconductor laser systems where one or a few edge emitting lasers were used in linear arrangement. Single channel use of modulators with edge emitting lasers in a package is also therefore possible. However, presently, two dimensional arrays of edge emitting semiconductor lasers are not in the prior art, hence integration of modulators with such lasers is not possible in the prior art. In addition, modulators that can be integrated with arrays of vertical emitting format lasers, particularly, vertical emitting cavity, distributed feedback (DFB) lasers and distributed Bragg reflector (DBR) lasers, are not available in the prior art.
EP-A-0760544 discloses an integrated device with a monolithically formed light emitting element and external modulator/light receiving element.
According to the invention there is provided a unit according to claim 1.
Further embodiment are defined in dependent claims 2-10.
As shown in FIG 1. we integrate arrays of vertical cavity modulators 1-100 on top of arrays of lasers 1-102 which are integrated on top of electronics 1-104 (one or more chips).
By employing the teachings of the invention, we create large laser arrays in which each of the lasers can be operated at constant light output and the output can be switched on and off, very rapidly, via external modulation through integration of the modulator array on top of the laser array. As a result, we can accomplish a number of advantages including switching lasers in a two-dimensional semiconductor laser array at rates both below, and in excess of, 10Gb/s.

The advantages and features described herein are a few of the many advantages and features available from representative embodiments and are presented only to assist in understanding the invention. It should be understood that they are not to be considered limitations on the invention as defined by the claims, or limitations on equivalents to the claims. For instance, some of these advantages are mutually contradictory, in that they cannot be simultaneously present in a single embodiment. Similarly, some advantages are applicable to one aspect of the invention, and inapplicable to others. Thus, this summary of features and advantages should not be considered dispositive in determining equivalence. Additional features and advantages of the invention will become apparent in the following description, from the drawings, and from the claims.

### BRIEF DESCRIPTION OF THE DRAWINGS

FIG. 1 is a simplified representation of an array of modulators on top of an array of lasers on top of an electronic integrated circuit;
FIG. 2 shows a modulator having connections formed for mating with connections on an example integrated laser device previously integrated with an electronic chip;
FIG. 3 shows an alternative modulator having connections formed for mating with connections on a laser device using a back side process;
FIG. 4 shows a modulator unit for use with discrete redundant lasers or a single laser having redundant active regions;
FIG. 5A shows an edge-emitting DFB of the prior art;
FIG. 5B shows an edge-emitting DBR of the prior art;
FIG. 6 shows the parallel transceivers created by integrating the devices, one-at-a-time, in a one-dimensional (i.e. linear) array;
FIG. 7A shows an upwards or "top" emitting grating coupled laser;
FIG. 7B shows a downwards or "bottom" emitting grating coupled laser;
FIG. 7C shows an upwards or "top" emitting micromirror coupled laser;
FIG. 7D shows a downwards of "bottom" emitting micromirror coupled laser;
FIG. 8 shows a two-dimensional array and integrated intimately with drive electronics present in the integrated circuit on which they were mounted;
FIG. 9 shows a side view of portion of an integrated unit made up of a two dimensional array of grating coupled DBR lasers integrated with modulators and an electronic integrated circuit by applying the teachings of the invention;
FIG. 10 is a prior art approach to integrating a top side active device with electronics;
FIG. 11 is an example of an example approach to integrating a top side active device with electronics;
FIG. 12 is an example of a process for forming a topside active optical device in accordance with the teachings of the invention;
FIG. 13A is an cutaway side view of a portion of a device wafer processed in accordance with the FIG. 12 variant of the invention;
FIG. 13B shows an alternative variant of the process of FIG. 12;
FIG. 14 is an example of an alternative variant of a process for forming a topside active optical device in accordance with the teachings of the invention;
FIGS. 15A through 15G are examples of configurations of units that can be made using devices created in accordance with the teachings of the invention;
FIG. 16 illustrates approaches that have been used in the prior art to attach multiple bottom emitting devices to form an integrated electro-optical chip ;
FIG. 17 illustrates approaches that have been used in the prior art to attach multiple bottom emitting devices to form an integrated electro-optical chip;
FIG. 18 illustrates a single optical device with contact pads placed in the position specified by its manufacturer and a portion of an electronic wafer with contact pads placed in the position specified by its manufacturer;
FIG. 19 illustrates a single optical device with contact pads placed in the position specified by its manufacturer and a portion of an electronic wafer with contact pads placed in the position specified by its manufacturer of which each will not be aligned;
FIG. 20 illustrates in simplified high level overview, one example approach according to the teaches of the invention;
FIGS. 21 and 22 illustrates several different access way variant examples;
FIG. 23 illustrates an optical array in which fibers are supported by the substrate;
FIG. 24 illustrates an optical array that accommodates an array of microlenses;
FIG. 25 illustrates one example process for creating an electro-optical chip variant according to the techniques described;
FIG. 26 illustrates one example process for creating an electro-optical chip variant according to the techniques described;
FIG. 27 illustrates one example process for creating an electro-optical chip variant according to the techniques described;
FIG. 28 illustrates one example process for creating an electro-optical chip variant according to the techniques described;
FIG. 29 illustrates another opto-electronic device being created in a manner similar to the devices of FIGS. 25-27;
FIG. 30 illustrates a process usable for bottom active devices;
FIG. 31A illustrates a process usable for topside active devices;
FIG. 31B illustrates the process where the contact holes are coated, but not filled, and can assist in alignment;
FIG. 31C shows an optical chip with its contacts rerouted by patterning traces on the substrate to match the contacts on another chip;
FIG. 31D shows the contacts on an electronic chip rerouted by patterning traces on the substrate to match the contacts on an optical chip;
FIG. 32 illustrates a process similar to that shown in Figure 31A except that a carrier is not used;
FIG. 33 illustrates a connection chip or adapter chip used to connect different devices;
FIG. 34 illustrates another alternative implementation, which is a further variant of the adapter or connection chip variant, usable for topside active devices;
FIG. 35A illustrates the stacking of two or more devices using one of the techniques according to the invention;
FIG. 35B illustrates a modulator stacked on top of a laser using one of the techniques according to the invention;
FIG. 36 illustrates an array of, for example, one hundred lasers created using one of the techniques according to the invention;
FIG. 37 illustrates the steps in creating an array for a DWDM application using one of the techniques according to the invention;
FIG. 38 illustrates the process of FIG. 37 from a top view;

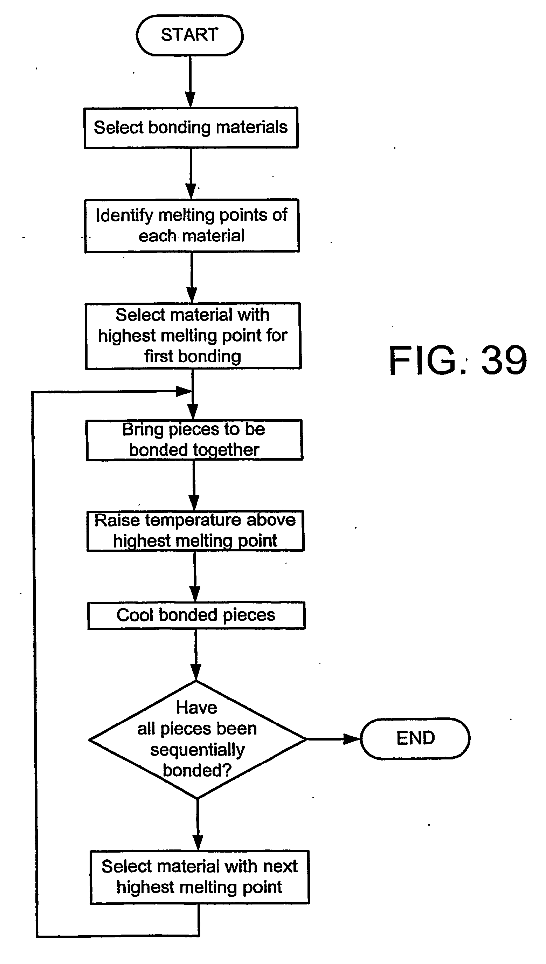

FIG. 39 is a flowchart for one example process in accordance with the invention;

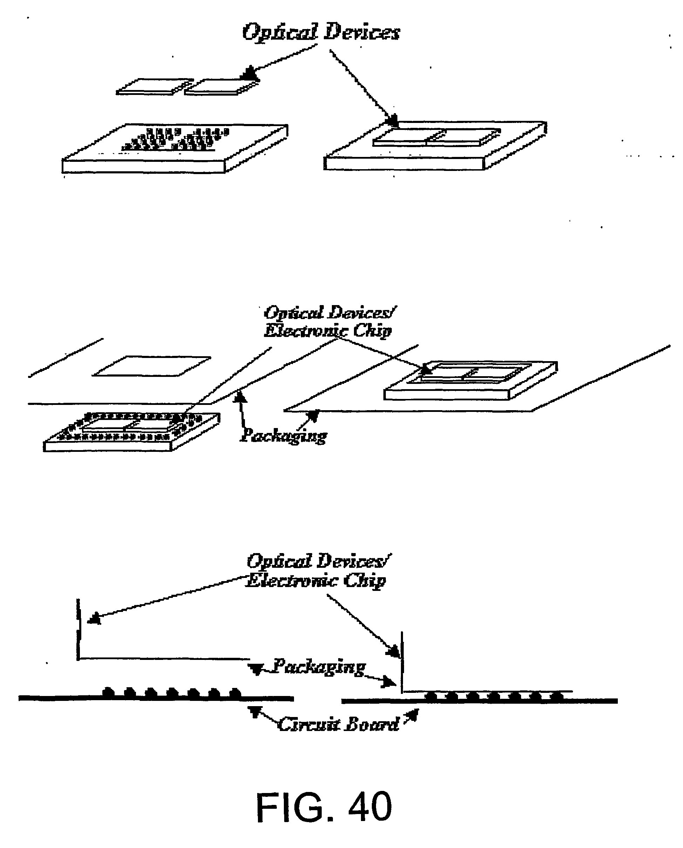

FIG. 40 shows the various components being joined according to the process of FIG. 39;

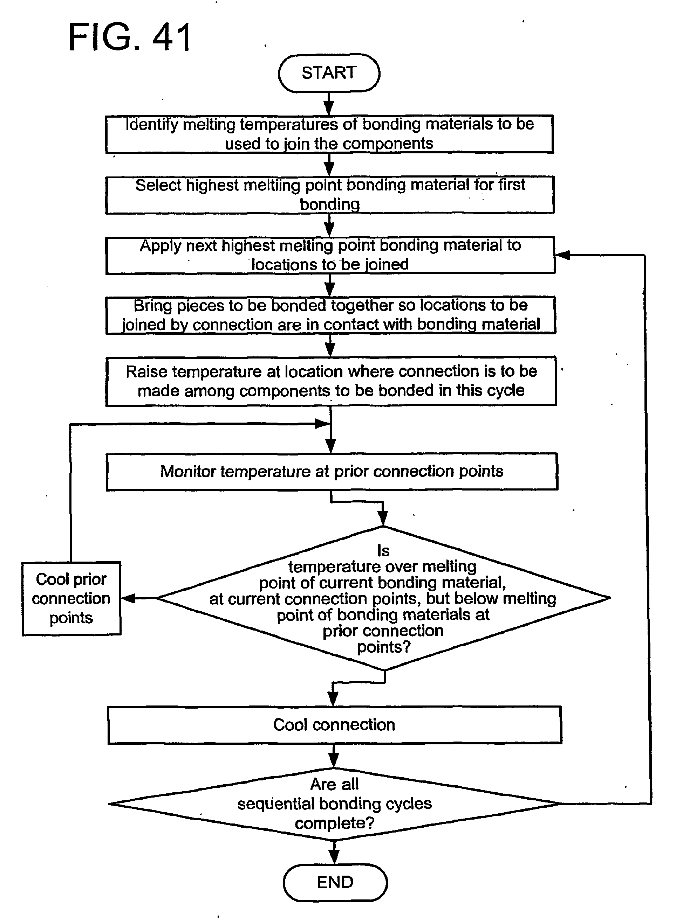

FIG. 41 is a flowchart for another example process in accordance with the invention; and

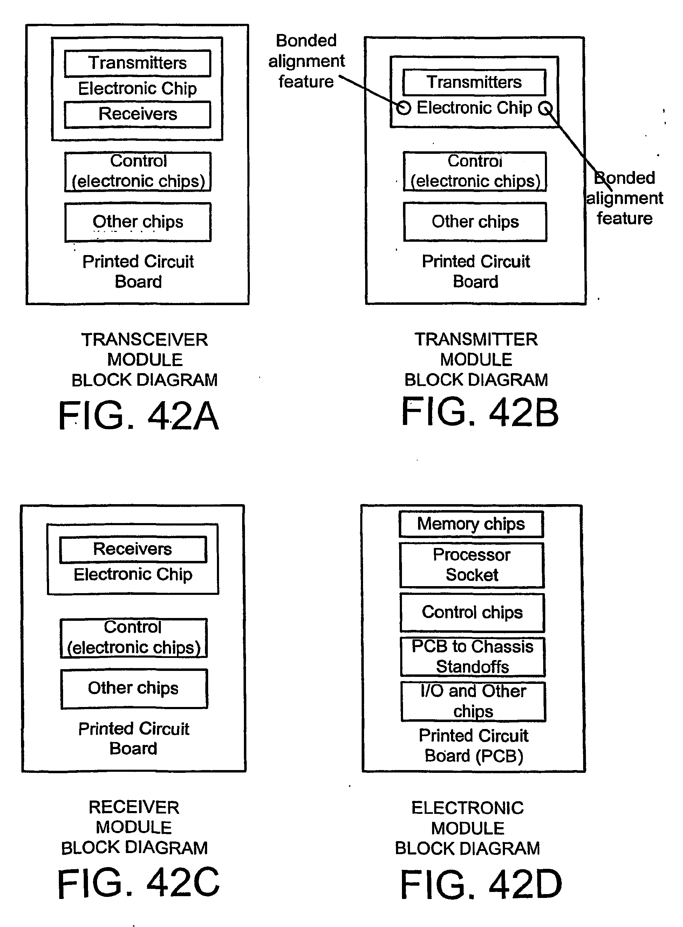

FIGS. 42A-42D show example assemblies constructed in accordance with the invention according to the teachings described herein.

### DETAILED DESCRIPTION

Commonly assigned U.S. Patent Application Serial Nos. 09/896,189, 09/897,160, 09/896,983, 09/897,158 and 09/896,665 and United States Provisional Patent Application Serial Nos. 60/365,998 and 60/366,032 describe different ways for integrating optical devices, including, but not limited to, vertical cavity surface emitting lasers (VCSELs), distributed feedback (DFB) lasers and distributed Bragg reflector (DBR) lasers, with electronics, irrespective of whether they are top-side or bottom/back-side emitting, to form large optical device arrays and for creating modules incorporating the resulting integrated opto-electronic chips.

At high data rates, for example, about 10Gb/s or more, it becomes difficult to turn lasers on and off rapidly enough to accomplish data transmission by direct modulation of the lasers. This is because when directly modulating a laser, electrons must be fed into the laser device in order to create light and then pulled out of the laser device to turn off the light during switching. However, this process requires a minimum amount of time and power to execute, due to fundamental physical properties of the laser, such as the capacitance of the device and the decay time constant of electrons in the laser's active region.

As speeds become higher, the required rate of switching approaches, and then eventually exceeds, the minimum time required to do so. As a result, as speeds increase, the process becomes extremely difficult (and eventually impossible) to perform.

As a result, at higher speeds, optical data transmission is often accomplished using what is called "external modulation" in which a lasers remains continuously "on" and a device external to the laser controls the light output. In one type of external modulation, a device known as a "modulator" is placed between the output portion of the laser and the external world. The modulator turns the light on and off thereby creating the effect of turning the laser on and off. A modulator can turn on and off the light, relative to the external world, via a number of mechanisms. For example, a modulator can be transparent in one state and absorptive in another, a modulator can be transparent in one state and reflective in another, a modulator can use changes in refractive index to shift the resonance wavelength of the laser so that the cavity resonant wavelength is no longer on the gain region, or a modulator can be irrelevant to and then disruptive to the optical properties of the laser (for example by changing the effective reflectivity of one of the laser's mirrors in a switchable fashion).

Our aforementioned applications and the description herein, describe processes that can be also be used to integrate a large array of modulators with an array of active optical devices (e.g. lasers and/or detectors) on an electronic chip.

We specifically describe herein some modulator specific aspects of the previous approaches to ensure that modulators are made compatible with the vertically emitting lasers described therein and to ensure the modulators are made electrical contact compatible with an electronic chip already containing lasers.

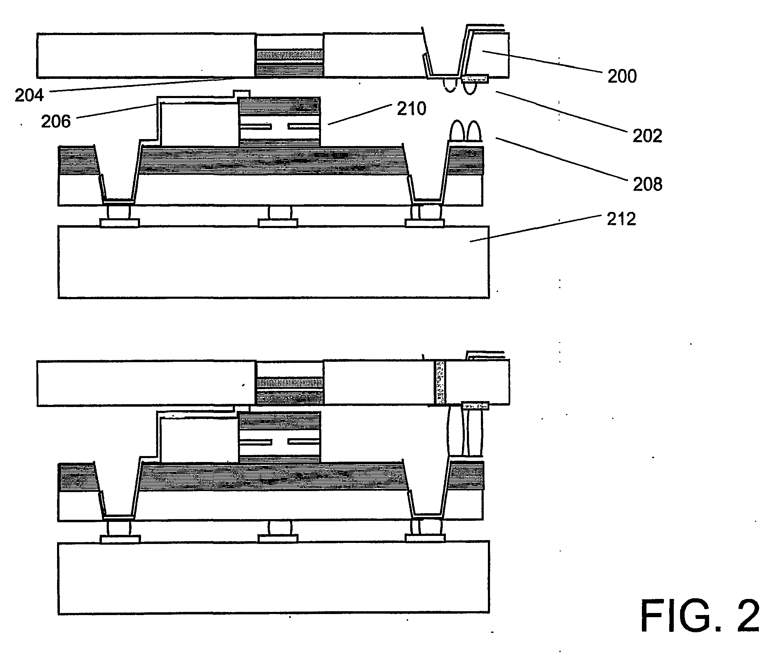

FIGS. 2 through 4 show example formats for integration of an individual modulator in an array of modulators, it being understood that the process can be preformed in the same manner on an individual device or wafer scale basis.

FIG. 2 shows a modulator 2-200 having connections 2-202, 2-204 formed for mating with connections 2-206, 2-208 on an example integrated laser device 2-210 previously integrated with an electronic chip 2-212, in this case a VCSEL. In FIG. 2, the connections for the modulator were made using one of the topside processes described herein. In the lower half of FIG. 2 the devices after the contacts have mated and been bonded.

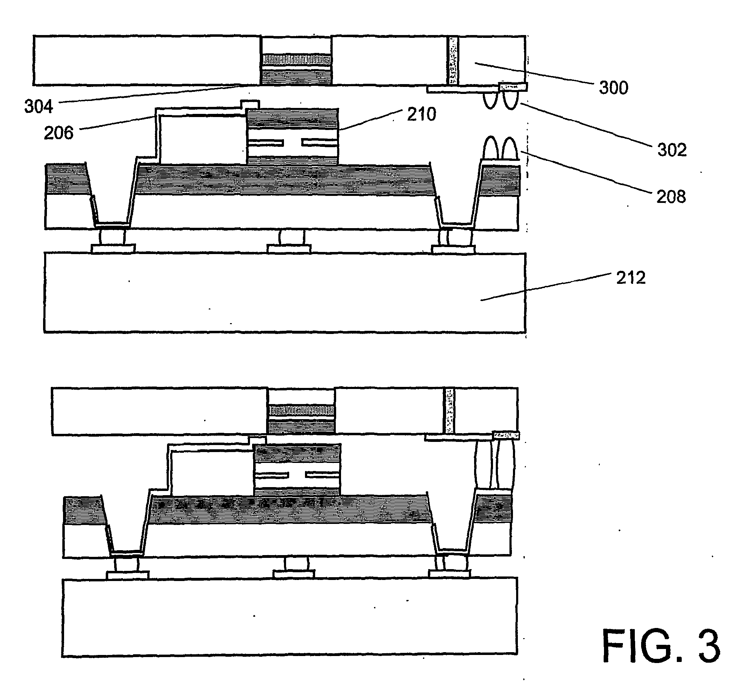

FIG. 3 shows an alternative modulator 3-300 having connections 3-302, 3-304 formed for mating with connections 3-206, 3-208 on a laser device 3-210 of FIG. 2, using a back side process as described herein, and, in the lower half of the figure, the devices after the contacts have mated and been bonded.

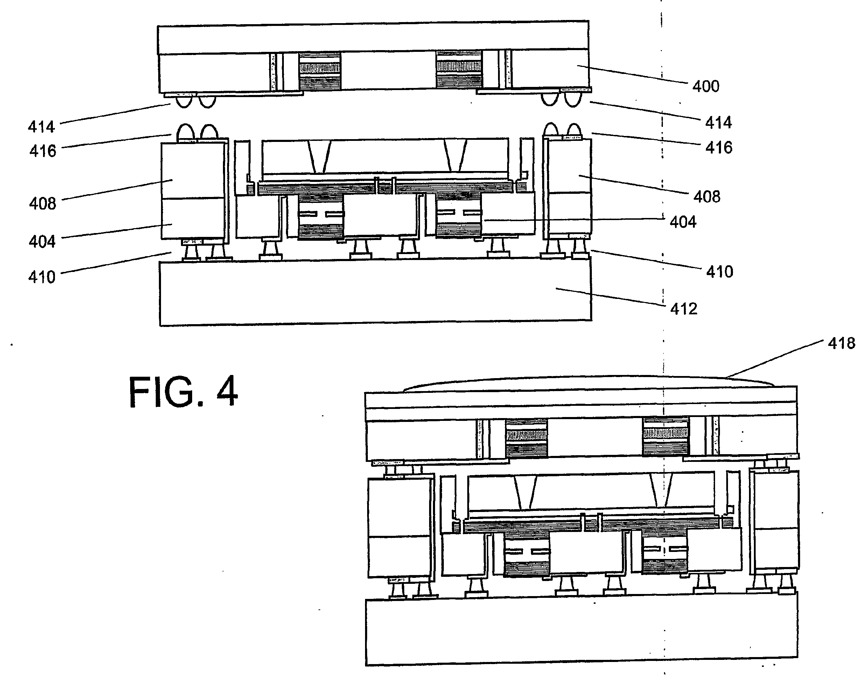

FIG. 4 shows a modulator unit 4-400, for use with discrete redundant lasers 4-402, 4-404 or a single laser having redundant active regions (not shown). In this configuration, separate standoffs 4-406, 4-408 are used to physically elevate the contacts 4-410 of the electronic chip 4-412 to where the modulator unit's contacts 4-414 can mate with the elevated contacts 4-416. The lower half of the figure shows the modulator unit 4-400 after it has been located above the lasers 4-402, 4-404 integrated with the electronic chip 4-412. In addition, as shown in the lower half of FIG. 4, a lens 4-418 is mounted on top of the modulator to allow coupling of emitted beams from the lasers with a common fiber or other element (not shown).

As noted herein and in the aforementioned applications, preparation and integration processes are slightly different depending upon whether the lasers (or detectors) and modulators are optimized for light emitting from/entering in from the top of the respective devices or the bottom (i.e. backside) of the respective devices, whether or not through a substrate.

Three representative alternative implementations, created according to one of the processes described herein or of the aforementioned applications provide for the interconnection between a modulator and a laser. These representative implementations are shown in FIGS. 2 through 4, although other implementations can be made in addition to those shown herein through application of those techniques.

The basic approach comprises:

Integrating lasers in a large array onto an electronic chip. As described in the sections below entitled "Opto-Electronic Device Integration" and "Successive Integration of Multiple Devices Process and Products, this is done using either a) bottom emitting lasers, where a funnel or other opening is etched into the substrate, the substrate is partially or completely removed to allow optical access, or with no substrate removal, if the substrate is optically transparent at the laser's wavelength, or b) top emitting lasers (i.e. emission of the laser is not towards the substrate).

Ensuring that the lasers have "pass-through contacts" which allow electrical connection to be made between the top of the laser wafer piece and the bottom of the modulator piece via contacts on the top of the laser piece and bottom of the modulator piece, without the electrical contacts impacting the performance of the laser itself. In other words, the contacts allow the modulators to be electrically connected to the electronic wafer through the intervening laser wafer).

Creating an array of modulators which allow optical access into and out of the device and have all their electrical contacts on the same side of the wafer piece that will be closest to the lasers and arranged in a configuration that matches with the configuration of the "pass-through contacts" on the laser piece.

Integrating the modulators with the laser wafer piece in a similar way to the way lasers are integrated onto the electronic chip in the array.

A number of schemes for creating the passthrough regions and the formatting of the optical devices (either modulators or lasers) are described below in the section entitled "Topside Active Optical Device Apparatus And Method".

It should be understood that the modulators can also have a substrate attached to them. Depending upon the particular implementation, a funnel or other opening can therefor be made using one of our techniques (or some other technique) in the substrate, the substrate can be thinned, or the substrate can be left alone if it is optically transparent to the laser below. Moreover, depending upon the particular modulator and its substrate location (i.e. top or backside), the funnel or other opening can be directed toward the lasers or toward the outside world.

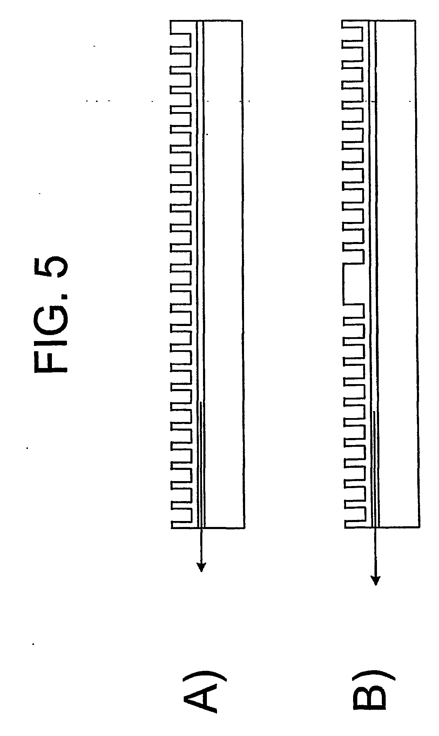

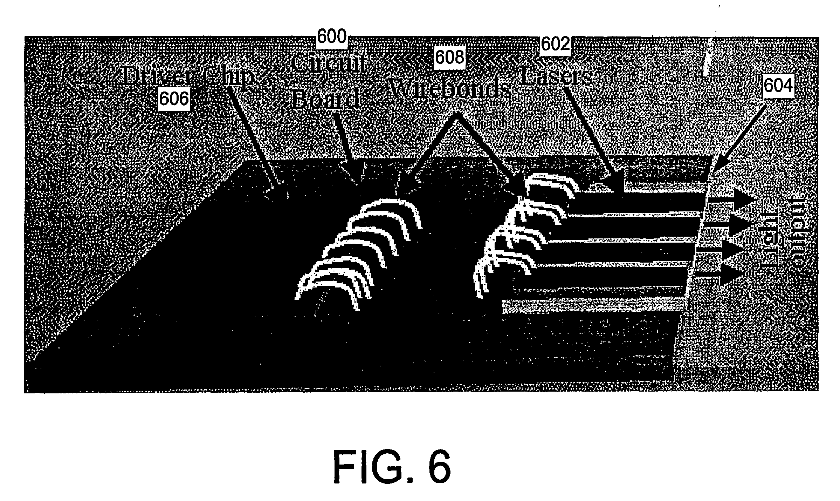

While others had proposed using DFB lasers in parallel transceivers, they have typically been thought of and used strictly as edge-emitting devices (i.e. outputting parallel to the plane of the wafer). FIG. 5A shows an edge-emitting DFB of the prior art and FIG. 5B shows an edge-emitting DBR of the prior art. Thus, the parallel transceivers using these edge emitting devices have been created by integrating the devices, one-at-a-time, in a one-dimensional (i.e. linear) array. This is shown in FIG. 6. In FIG. 6, a circuit board 6-600 has the individual edge emitting array of lasers 6-602 mounted along its edge 6-604. An integrated circuit chip 6-606, containing the driver circuits for the lasers 6-602, is connected to the lasers 6-602 by a series ofwirebonds 6-608 via the circuit board 6-600.

Since, as noted above, our techniques are usable with any upwards or downwards emitting (or receiving) devices, we recognized that our invention was also usable with grating coupled or angled micromirror coupled DFBs or DBRs, for example, because the grating or micromirror cause their emitted beams to travel perpendicular to the plane of the wafer, such "top" or "bottom" emitting devices having been created by others in the prior art to facilitate on-wafer testing of those devices. FIG. 7A shows an upwards or "top" emitting grating coupled laser of the prior art and FIG. 7B shows a downwards or "bottom" emitting grating coupled laser of the prior art. Similarly, FIG. 7C shows an upwards or "top" emitting micromirror coupled laser of the prior art and FIG. 7D shows a downwards or "bottom" emitting micromirror coupled laser of the prior art.

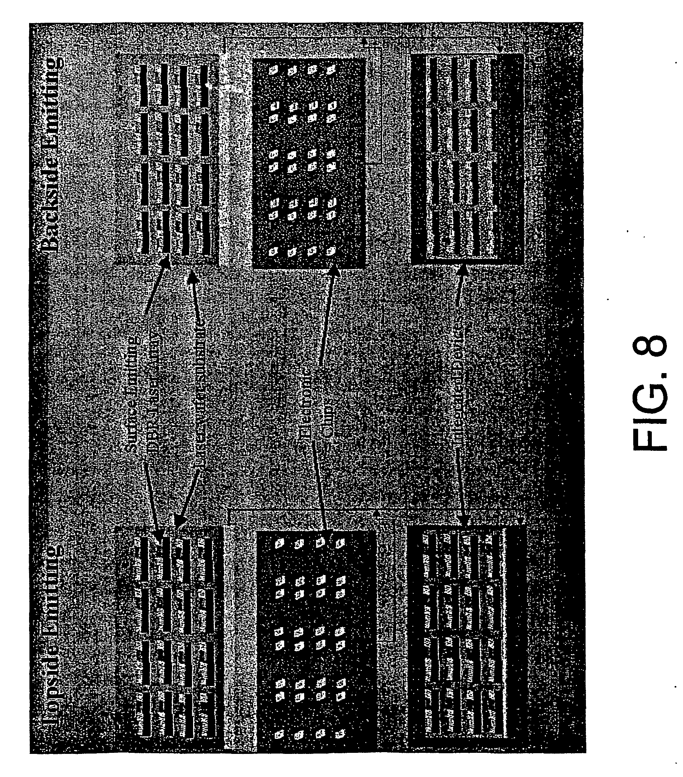

As a result, our approach made it possible for those perpendicular emitting DFBs or DBRs to be configured in a two-dimensional array and integrated intimately with drive electronics present in the integrated circuit on which they were mounted, such as shown in FIG. 8.

Advantageously, as we described, the integration of modulators with lasers is equally valid for a variety of lasers, provided that the light from those lasers eventually emits vertically. Thus, for example, a surface emitting DFB or DBR, such as a grating coupled DFB or a DBR coupled with a mirror, can be used to equal (or greater) effect and/or advantage than achievable with VCSELs.

As described herein and in the applications referred to above, by applying the teachings of our inventions as described therein, large-format two-dimensional transmitter or transceiver arrays containing VCSEL, DFB or DBR lasers and electronics can be made.

While VCSELs have the advantage of being a more mature and available technology, VCSELs have certain limitations. The output power they can provide is limited. The maturity of longer wavelength VCSELs, for example, at wavelengths of 1.3 microns and beyond, is less than at shorter wavelengths, and the chirp parameter (characterized by the wavelength spread or the change in phase of the output wave during switching) tends to be high. These characteristics limit the usefulness of VCSELs for longer distance data transmission at ultra-high speeds. DFB lasers have superior characteristics which allow longer distance, high-speed data transmission. Accordingly, for long distance data transmission at speeds in excess of 10Gb/s, DFB lasers are superior to VCSELs.

In contrast to using VCSELs, using our approach with DFBs or DBRs allows large numbers of high-power, narrower linewidth, low chirp, long wavelength lasers to be integrated together on an electronic chip. By doing so, extremely large bandwidth can be achieved (relative to the bandwidth achievable with VCSELs) because resistive losses and/or capacitive slowdowns are minimized. Thus, highly parallel (whether in space or wavelength), low cost, intelligent transmitters or transceivers can be made that can send data over several tens of kilometers which is farther than can be done with other laser technologies, such as VCSELs.

However, as with VCSELs, the desire for ever faster transmission rates means that, at some point, the time the DFB laser needs in order to switch will become longer than the data bit rate transmission time period. Thus, we can also straightforwardly create large arrays of DFB lasers with modulators closely integrated on top to achieve further benefits to those obtained using VCSELs.

By way of brief overview, the process for integrating the DFBs or DBRs with the electronics is the same as described for the specific VCSEL examples below. The process starts with a laser wafer or wafer piece containing large numbers of surface emitting DFBs or DBRs. These lasers are surface emitting because they have an element near their output, for example a grating or micromirror to couple the light perpendicular to the surface of the wafer (either away from the substrate or into the substrate).

Then, depending upon whether the device is configured to emit away from the substrate (i.e. "top" emitting) or towards it (i.e. "bottom" emitting) the appropriate process is performed as described in detail herein.

If the devices are topside emitting devices: the laser wafer is attached to a carrier; if necessary, the laser wafer substrate is thinned; contacts are pattern etched on the back side of laser wafer in a pattern such that they will match the contacts of the electronic wafer containing the drive circuits; if desired, an encapsulant is optionally flowed between the laser and electronic wafers; and the laser and electronic wafers are attached to each other at the contacts.

If the devices are bottom emitting devices, contacts are pattern etched on the top side of laser wafer so as to match the contacts of the electronic wafer containing the drive circuits; and the laser wafer is then attached to the electronic wafer. Optionally, as with the topside emitting device process, an encapsulant can be flowed between the wafers and/or the laser substrate can be thinned if necessary or desired.

These processes result in integrated devices which contain the various grating coupled DFB lasers integrated with electronics. Although the approach can be performed without them, consistent with semiconductor creation and etching techniques, making these edge-emitting-type laser structures so that they contain etching layers and etch stop layers to help with fabrication of the contact layers and, potentially with the substrate thinning process is beneficial for commercial scale production.

FIG. 8 shows, in summary fashion, the process steps and the end result of the process, which serves as the starting point for the similar process of integrating modulators or detectors on top of the lasers in the array.

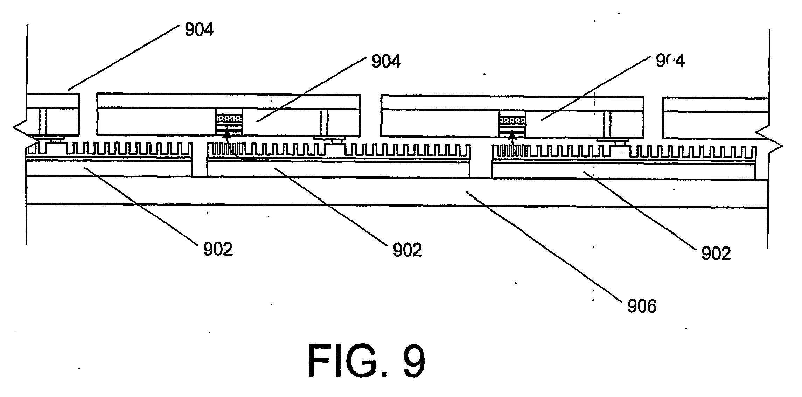

FIG. 9 shows a side view of portion of an integrated unit 9-900 made up of a two dimensional array of grating coupled DBR lasers 9-902 integrated with modulators 9-904 and an electronic integrated circuit 9-906 by applying the teachings of the invention described herein.

In another variant created according to the teachings of the invention, the modulators can be replaced by detectors that are mostly optically transparent to the laser wavelength and integrated on top of the lasers in a similar manner. Alternatively, the modulators can be operated as detectors to absorb an amount of light from the lasers as the light passes through them. In other variants, both a modulator and detector or two modulators can be stacked above the laser using the same procedures.

In those cases, the detector or modulator would then provide a sampling of the output power from the lasers. The absorbed light will generate a current which can be routed to the integrated circuit and measured. If the power of the laser changes, for example, due to temperature changes or degradation of the laser over time, the absorbed current will change proportionally. As a result, the electronic chip could inject more current into the laser to keep the output power constant or, if redundancy is provided and a laser either could not put out enough power (i.e. it was effectively dead) or died, a backup laser could be switched on its place.

Depending upon the particular implementation and needs, the fixed detector would be used to absorb a small amount of light and let the large majority of light through, in which case the laser would be directly modulated.

In other implementations, the laser is externally modulated, by using the upper device as a modulator and then using a lower modulator to sample the output power by absorbing some of the light, either in the "on" state or the "off" state, or some weighted average of both, for example, where a modulator is transmissive in the "on" state and absorbs in the "off" state; this means the modulator will let light through in the "on" state and block light in the "off" state. However, in actual operation, some amount of light will normally be absorbed, even in the "on" state due to the laws of physics and properties of the devices. As a result, in actual operation, the generated current in the "on" or "off" state, or some average can be used, depending upon which works best in the particular design.

In still other implementations, the devices are arranged in a stack in different orders, for example: a) electronics, detectors, lasers, modulators; b) electronics, lasers, detectors, modulations; or c) electronics, lasers, modulators, detectors.

### Topside Active Optical Device Apparatus And Method

Top side emitting/processed devices are ones in which the optical devices are oriented away from the substrate of the wafer on which the devices were formed (i.e. containing the optical devices). Bottom (or back) side emitting/processed devices have the optical devices themselves oriented towards the substrate.

Top side emitting/receiving devices are the common device configuration used by industry and so are more readily available, more easily obtained, and more widely understood and characterized.

Moreover, top side emitting lasers, receiving detectors, or reflective or absorbative modulators can be easily made to operate at wavelengths at which the substrate for the optical devices is opaque, since in these types of devices light does not need to travel through the substrate.

In addition, top side emitting/receiving/processed devices are easier to test than bottom side devices, before integration with electronics, since contacts and optical access are on the same side (top) of the wafer.

The driver and control circuitry for these devices is most commonly fabricated from silicon circuits. The electrical contacts are also on the front (i.e. top) surface of the driver and control circuitry silicon wafer. Where the electrical contacts of top side of the optical devices and driver and control circuitry chip, it is difficult to connect them together. Inverting the top side optical devices would allow electrical interconnection to the driver and control circuitry but prevents correct optical functionality, absent a hole being made in the electronic driver chip.

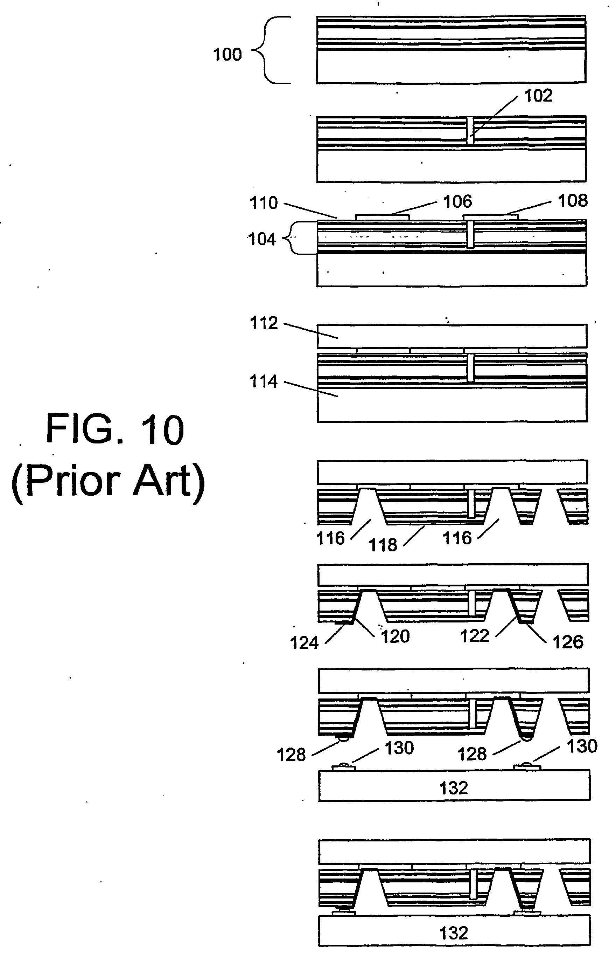

Others have attempted other ways of integrating of top emitting devices with electronics. One approach to doing so is shown in FIG. 10. In the process of FIG. 10, the process starts with a wafer 10-100. One or more isolation holes, grooves or trenches 10-102 are made in the epitaxial layers 10-04 and contacts 10-106, 10-108 are formed on the top surface 10-110. A superstrate 10-112 is attached to the upper surface 10-110 for strength. The substrate 10-114 of the wafer 10-100 is then completely removed. The optical devices are then defined in the epitaxial layers 10-104. Vias or other openings 10-116 are then made from the bottom (also called the "back") side 10-118 through the epitaxial layers 10-104 to the underside contacts 10-106, 10-108. After an insulator (not shown) has been applied to the vias 10-116 as necessary to ensure an electrical short does not occur, conductors 10-120, 10-122 are formed on the side of the vias 10-116 so as to, in effect, provide an ability to connect to the electrical contacts 10-106, 10-108 on the bottom side 10-118 via the conductors 10-120, 10-122 and contacts 10-124, 10-126 formed on the bottom side 10-118. Solder can then be applied for connection of the top emitting device to other electrical contacts 10-130, for example, on a circuit board 10-132 or another wafer.

The complexity of this approach, the difficulty in attaching a superstrate and keeping that superstrate robust over operational temperature cycling, and difficulty in achieving reasonable yields, make this approach undesirable for commercial application.

Thus, there is a need for a process that can make top side optical devices that can be integrated with electronics that does not suffer form the above problems.

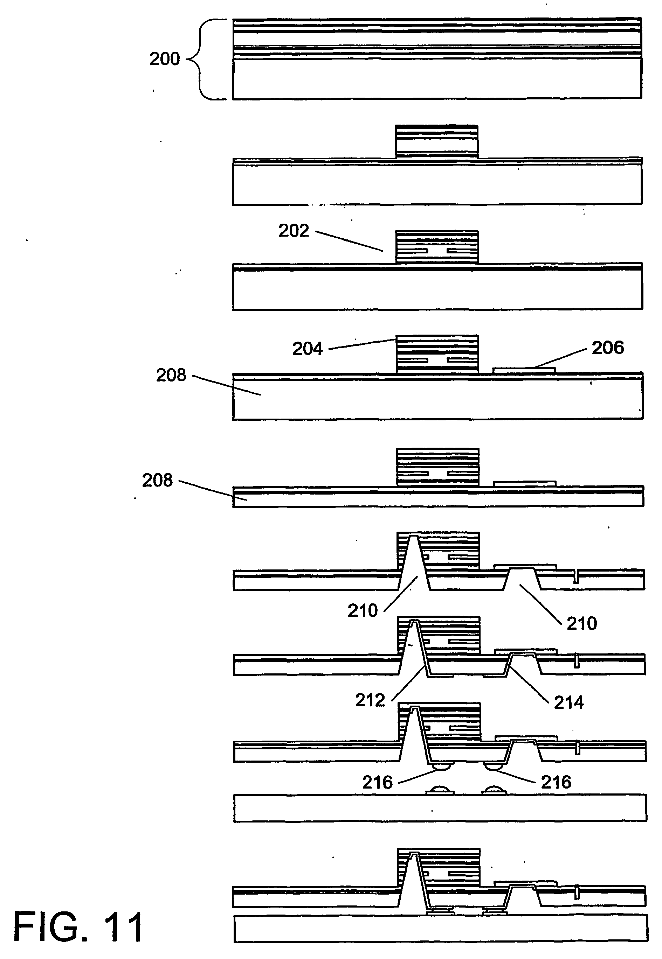

While, to avoid the thermal problems of the prior art associated with the superstrate, one might consider adapting the prior art approach by an analogous approach of not using a superstrate and etching through the substrate, such as shown in FIG. 11.

In the process of FIG. 11, a wafer 11-200 is etched and doped to form the optical device 11-202. Contacts 11-204, 11-206 are formed on the device. The substrate 11-208 is thinned to allow for the etching of vias. Vias 11-210 are then etched through the substrate 11-208 until the contacts 11-204, 11-206 on the top of the device are reached. A dielectric (not shown) coating is made on the via wall and a conductor material is added into the hole, on top of the dielectric, to form a contacts 11-212, 11-214 extending from the back side to the contacts 11-204, 11-206 on top. Solder or some other electrically connective material 11-216 can then be added to the contacts for joining the device to another device.

However, while the process of FIG. 11 addresses the problems of the prior art, particularly those caused by the superstrate, that process does not remedy the other problems in the prior art. For example, alignment between the features on the two sides of the wafer must still be properly carried out, so there is still a risk of damage to the optical devices, particular as densities of devices per chip increase.

Thus, we have developed a fabrication technique for creating top emitting/receiving/modulating structures, such as VCSELS, detectors or modulators, that can be closely integrated with electronic circuits. It allows alignment-dependent processing to occur only on the top side of the optical devices, thus reducing, if not eliminating, the need for backside alignment processing in which precision elements on two sides of a wafer have to be aligned relative to each other.

Since new VCSEL developments are first implemented in top-emitting devices, our approach allows use of the newest technologies, for example, the present 1310 micron or 1500 micron wavelength VCSELs.

In addition, through use of the teachings of the invention, costs are lowered because, instead of having to fabricate special purpose devices, the devices can be procured from multiple vendors as "off-the-shelf" items.

Our approach can also result in improved product lifetimes and overall yields since industry standard semiconductor processing techniques are used in the individual fabrication steps.

By employing the teachings of the invention, a higher density of interconnects is possible. As a result, in some implementations, the invention allows for close interconnect spacing, for example as close as a 20 micron pitch in current technologies and smaller in the future.

In addition, by forming interconnections through the substrate, interconnection points are not limited to the periphery of the chip. The entire otherwise unused surface is available for potential interconnections.

By employing the teachings of the invention, more direct interconnects between driver circuits and optical devices can be made. This lowers the resistance, capacitance and inductance of the interconnect. As a result, parasitics are reduced, making for lower power and drive requirements and increased device speed.

In addition, manufacturability is improved because the interconnects can be fabricated when the optical device is either in die or wafer form. Moreover, in either case, the interconnects can be fabricated in the die or wafer all at once. Alternatively, in alternative variants, a similar technique can be used where both the optical devices and electronic chips are individual dies, where the optical devices are on dies and will be connected onto a driver circuit wafer, or where the optical devices and driver circuits are still both in wafer form.

A further advantage is that the vias, that are used to form the connections, can be fabricated during optical device manufacturing. In addition, substrate removal is simple and the process does not require additional processing once the substrate removal occurs.

A further advantage is that the process can be straightforwardly used for integration of different combinations of acoustic, thermal, optical, mechanical sensors, and active devices together or for combining two, three or more devices/wafers/chips together.

A further advantage achievable by employing the teachings of the invention is better thermal management of top-emitting VCSELs because they are heat sinked to the driver and control circuitry.

A still further advantage achievable by employing the teachings of the invention is that incorporation of an optical coupler, face plate, MEMS detectors, optical combiners, optical splitters, lens, micro lenses or other optical or electrical devices can be accommodated during the fabrication process.

It should be understood that a further advantage of the invention is its applicability to both light-emitting and light-detecting devices.

For completeness, specific details related to different aspects and variants of the current invention are set forth herein.

We have developed a process in which top side emitting lasers, top side receiving detectors, or top side processed modulators (hereafter referred to collectively as "topside optical devices"), are created so that they can be easily integrated onto electronic chips.

In overview, in accordance with the invention, the process of forming topside devices that can be integrated with electronics and do not suffer from the problems of the prior art involves etching deep trenches from the top side down into the substrate of the device containing wafer, patterning dielectrics and conductors on the walls of the trenches so that the conductors extend all the way to the bottoms of the trenches. The substrate is then thinned either just down to the point where the bottom of the conductor region in the trench is exposed or until a small hole connects the thinned side of the substrate to the trench, while leaving enough remaining substrate to protect the topside optical devices from damaging levels of stresses.

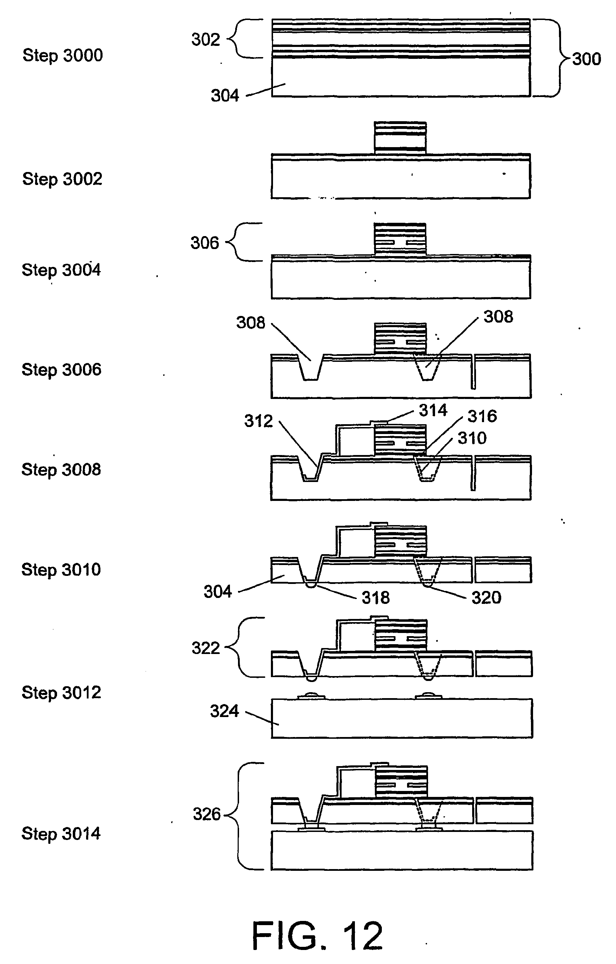

With that overview, an overall example process for forming a topside optical device, in accordance with the teachings of the invention, will now be presented in detail with reference to FIG. 12.

As shown in FIG. 12, an optical wafer 12-300 containing epitaxial layers 12-302 on a substrate 12-304 is a meaningful starting point (Step 12-3000) for this example.

The optical devices 12-306 (only one of which is shown) are defined, for example, with a combination of doping, patterning, etching, oxidation and metalization (Steps 12-3002, 12-3004).

Deep trenches 12-308 are etched from the top side of the wafer into the substrate, for example, between about 20 microns and about 150 microns or more or so into the substrate, making sure that the profile of the trenches are acceptable to maintain good coverage of a later deposited conductor (for example, by having the slope of the wall be either vertical or inward tapering (looking from the top) rather than an outward tapering).

Dielectric material (not shown), if shorting is a concern, and conductors 12-310, 12-312 are deposited to form positive and negative device contacts 12-314, 12-316 (one of which is obscured from view in FIG. 3) for the topside optical device. In an alternative variant, the substrate can be used as one of the contacts, in which case only one deep trench need be made. Similarly, if a three or four terminal device, for example, a combination laser-detector device, laser-modulator, or laser-modulator-detector, is created then enough vias or trenches 12-308 are made to allow formation of contacts for all of the appropriate points on the topside optical devices (e.g. a four terminal structure would need four or fewer trenches, depending upon whether the substrate was used as a contact or if it is possible to combine several of the contacts in a single trench).

Next, the substrate 12-304 is thinned to the point where the conductors on the bottom of the trenches are exposed so that contacts 12-318, 12-320 are formed, or can be put, on the bottom of the wafer.

At this point, the topside optical device 12-322 is capable of being closely integrated with an electronic chip 12-324, for example, containing drive and control circuitry.

At some point later, the joining of the topside optical device 12-322 and the electronic chip 12-324 optical wafers forms an integrated optical unit.

In some variants, a polymer, for example polyimide, or a spun-on glass are added to the trenches after the contacts have been made or after the joining to add strength and/or prevent damage to the contacts.

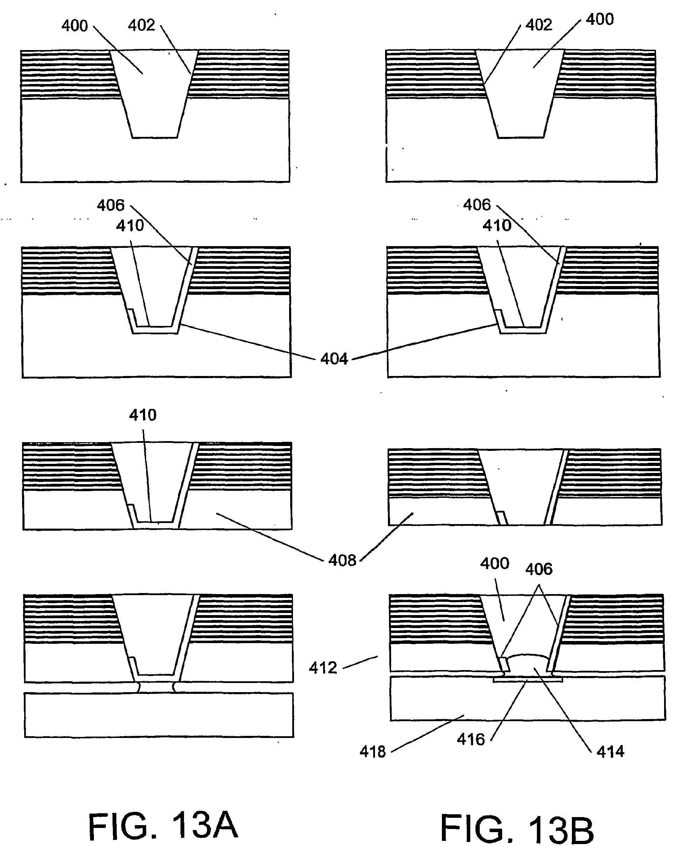

In another alternative variant, the processing proceeds as described above except, the thinning of the substrate does not stop when the conductor layer is reached. Instead, the thinning continues until there is a hole in the conductor layer. This difference is illustrated in FIGS. 13A and 13B that contrasts this variant's approach to that of FIG. 12

FIG. 13A is a cutaway side view of a portion of a device wafer processed in accordance with the FIG. 12 variant of the invention. In FIG. 13A, the hole 13-400 is made to have tapered walls 13-402. Insulating dielectric 13-404 and conductors 13-406 are added. The substrate 13-408 is then thinned. However, as shown in FIG. 13A, the thinning stops at a point between when the conductor 13-406 is exposed and a point prior to breaching the conductor inner surface 13-410.

In contrast, as shown in FIG. 13B, the thinning continues until there is an actual opening in the inner surface 13-410 of the conductor 13-406 (and any dielective that may be present on the surface).

By processing according to this variant, when the topside optical device 13-412 is brought into contact with a solder 13-414 on the mating contact 13-416 of an electronic chip 13-418, and the solder 13-414 is melted, capillary action will draw the melted solder 13-414 up into the cavity 13-400.

This provides at least two benefits. First, the passage of the solder into the hole will tend to draw the two pieces towards each other and into alignment. Thus, to some extent this variant is self aligning. Second, the drawing of the solder into the hole helps ensure a good electrical connection is made between the two devices.

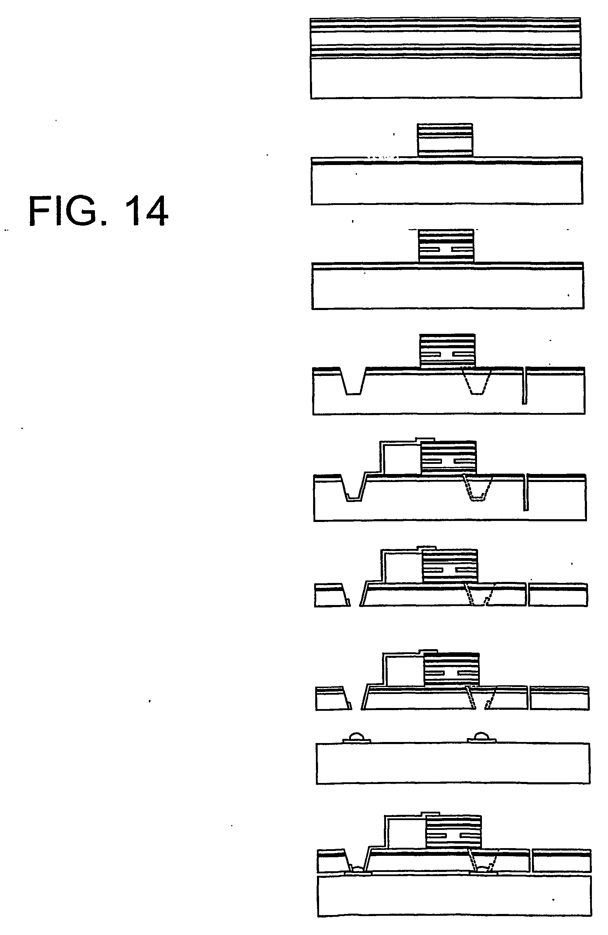

FIG. 14 is an example of an overall process similar to that of FIG. 12 except it is an example of a variant employing the technique of FIG. 13B.

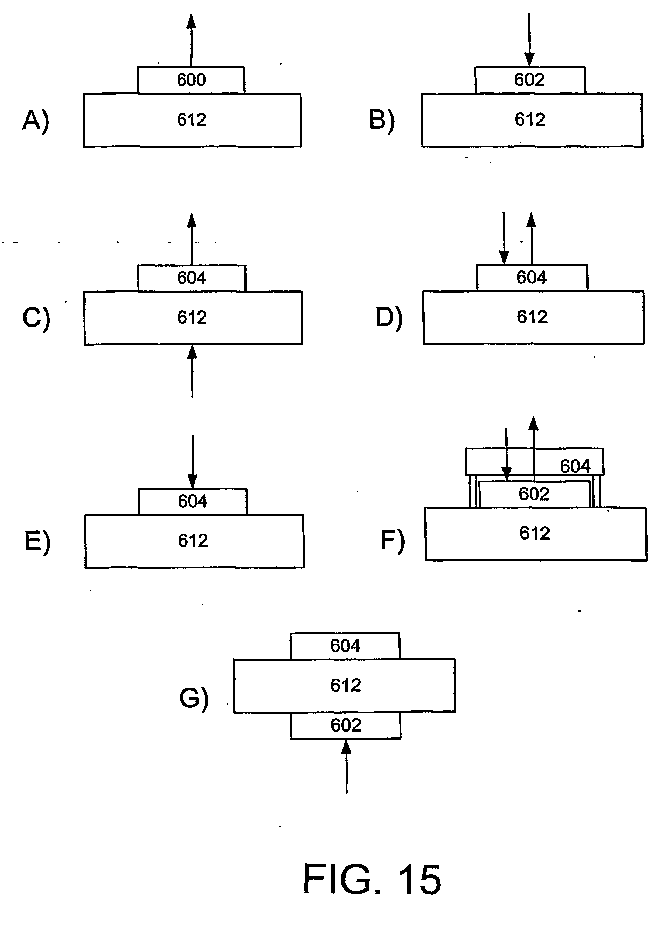

FIGS. 15A through 15L show some of the many configurations of devices that can be formed according to the present invention involving a topside optical device, for example a topside active laser 15-600, a topside active detector 15-602 or a topside processed modulator 15-604, according to the present invention, in conjunction with other laser 15-606, detector 15-608 or modulator 15-610 devices relative to a substrate 15-612 of the topside optical device.

### Opto-electronic Device Integration

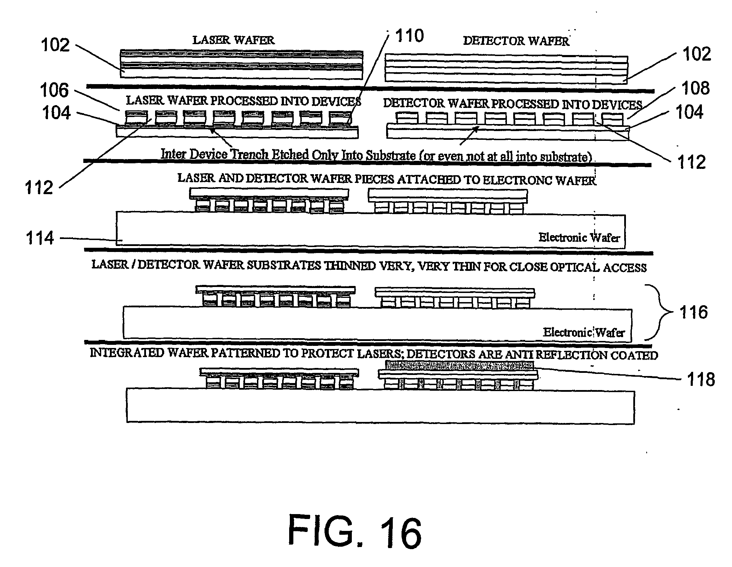

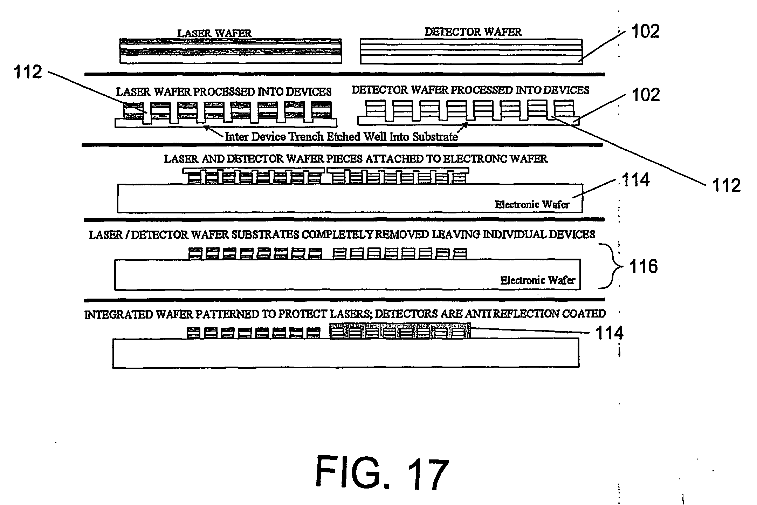

FIGS. 16 and 17 illustrate approaches that have been used in the prior art to attach multiple bottom emitting (or detecting) (also referred to as backside emitting (or detecting)") devices to form an integrated electro-optical chip.

According to the approach of FIG. 16, multiple lasers, are formed on a wafer substrate 16-102 in a conventional manner, as are multiple detectors (interchangeably referred to herein as photodetectors) on their own or on a wafer substrate in common with the lasers. Typically, the portion 16-104 of the substrate 16-102 closest to the junction between the optical devices 16-106, 16-108 and the substrate 16-102 is made of a material which is optically transparent at the wavelength at which the optical devices operate. The devices 16-106, 16-108 are then processed using conventional techniques such as wet or dry etching to form trenches 16-112 among the devices 16-106, 16-108 which separate them into a series of discrete individual lasers 16-106 or detector 16-108 devices. Depending upon the particular technique used, the etched trenches 16-112 may stop prior to reaching the substrates 16-102 or extend partly into the substrates 16-102. Following etching, the substrates 16-102 and their associated devices are inverted, aligned to the proper location over a Silicon (Si) electronic wafer 16-114, and bonded to the Si electronic wafer 16-114 using conventional flip-chip bonding techniques. Following bonding, the entirety of the substrates 16-102 are thinned extremely thin, by conventional mechanical polishing methods, conventional etch techniques or some combination thereof, to on the order of about 5 microns or less to allow for close optical access to the devices and create an integrated electro-optical wafer 16-116.

Optionally, the integrated electro-optical wafer 16-116 is then patterned, using conventional techniques, to protect the individual lasers and the individual detectors are coated with an anti-reflection (AR) coating 16-118.

A related alternative approach to the technique of FIG. 16 is shown in FIG. 17. In this approach, lasers and detectors are formed as described above. However, when the technique of FIG. 17 used, the trenches 17-112 are etched into the substrates 17-102. The substrates 17-102 and their associated devices are then inverted, aligned to the proper location over a Silicon (Si) electronic wafer 17-114, and bonded to the Si electronic wafer 17-114 using conventional flip-chip bonding techniques. Following bonding, the substrates 17-102 are then wholly removed, by conventional mechanical polishing methods, conventional etch techniques or some combination thereof, to allow for close optical access to the devices and create an integrated electro-optical wafer 17-116.

Optionally, the integrated electro-optical wafer 17-116 is then patterned to protect the individual lasers and the individual detectors are coated with an anti-reflection (AR) coating.

The techniques of both FIG. 16 and FIG. 17 make it possible to get optical fibers or optical lenses close enough to the devices to capture the appropriate light without allowing light coming from, or going to, adjacent devices to affect any of those adjacent devices, a problem known as "crosstalk". Typically, this requires that the separation distance between a device and an optical fiber or optical microlens be less than 100 microns.

Additionally, both techniques ensure that there are no significant absorbing layers over the active region of the devices that will prevent light from escaping since the thinning technique of FIG. 16 reduces the thickness of the entire substrate 16-102 to about 5 microns or less and the approach of FIG. 17 removes the substrate 17-102 entirely, leaving multiple wholly independent optical devices.

Both of these techniques however, characteristically create opto-electronic chips that have heat dissipation problems during use and leave the individual devices more sensitive to thermal and mechanical stresses produced during the manufacturing process, thereby reducing individual device lifetimes and, accordingly, decreasing yields and overall chip life.

Moreover, for the approach of both FIG. 16 (where the substrate is extremely thin) and FIG. 17 (where the substrate is completely removed), stresses experienced by the devices are primarily transferred to the very thin optical device layer which is the structurally weakest part of the device.

Thus, there is a need for a way to create an integrated opto-electronic chip that is not as sensitive to the thermal and or structural stresses resulting from processing and/or use.

In addition, a manufacturer of opto-electronic devices has two avenues for obtaining the optical and electronic wafer - they can manufacture either or both themselves, or they can obtain one or both from a third party. By manufacturing both the optical devices (interchangeably referred to for simplicity as an "optical chip") and the electronic wafer (interchangeably referred to for simplicity as an "electronic chip"), the manufacturer can take measures to ensure that the pads on each are properly placed so as to align with each other when the optical chip is positioned over the electronic chip. However, typically electrical and optical chips are not designed concurrently, even if they are designed and fabricated within the same organization. Thus, even with a single manufacturer, unless there is close coordination within the organization with regard to both the optical and electronic chip design, a lack of correspondence between contact pads on each can easily occur - particularly where one or both are also designed with sales to third parties in mind or integration with devices from other sources is contemplated. Moreover, subsequent improvements or changes in the design of either may necessitate altering the location of the contact pads, thereby introducing a pad misalignment where none previously existed.

Even worse, if the electronic chip is designed to be used with a variety of different optical chips, but the optical chips are commodity stock obtained from third parties (for example, chips containing: topside emitting vertical cavity lasers, bottom emitting vertical cavity lasers, distributed feedback (DFB) or distributed Bragg reflector (DBR) lasers (which each have better chirp and linewidth characteristics for long distance applications), topside receiving detectors or bottom receiving detectors) that are mass manufactured for distribution to multiple unrelated users, it is unlikely that the pads on the optical devices will all be located in the same place, even if they are otherwise compatible with the electronic chip.

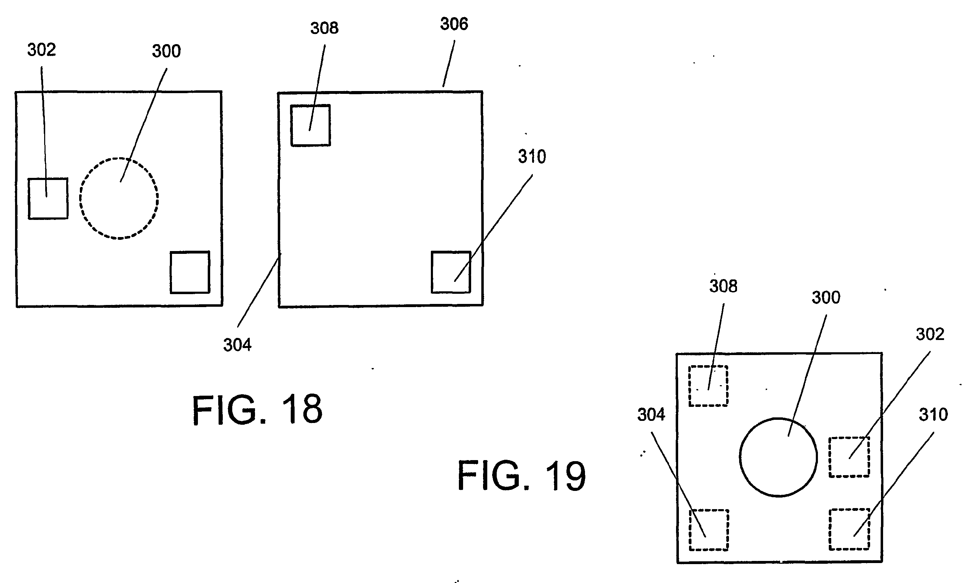

For example, as shown in FIG. 18, a single optical device 9-300 has contact pads 9-302, 9-304 placed in the position specified by its manufacturer. A portion of an electronic wafer 9-306 also has contact pads 9-308, 9-310, onto which an optical device can be connected, placed in the position specified by its manufacturer. If the optical device is flipped over, for flip-chip type bonding with the electronic wafer, the contact pads 9-302, 9-304,9-308,9-310, of each will not be aligned, as shown in FIG. 19.

This presents a problem in that it limits the ability to "mix-and match" devices. Moreover, if a chip is designed with connection to a particular other chip in mind, and subsequent events create a need to use a different device with a different contact placement, all the planning and coordination done for the original device will be irrelevant to the new device.

Thus, there is a further need for a process that facilitates the ability to mix and match devices without there being any coordination between the designers of either or the use of a standard or common contact placement scheme.

In addition, in some cases it is sometimes desirable to coat some of the devices, specifically the detectors, with an AR coating.

An AR coating prevents light from hitting the top of a detector device and being reflected at the detector-air interface due to the differences in the indexes of refraction. This is important for detectors because reflected light is light that does not enter the detector itself and hence can not be converted into electrical signals (i.e. it is 'lost light' from a system point of view). Thus an AR coating optimizes the collection efficiency of the detector because it prevents light from being reflected at that interface.

Lasers however, require a top mirror of very high in reflectivity in order to operate. AR coating on a laser changes the reflectivity of the top mirror. As a result, at a minimum it will detrimentally affect the lasing action of the laser, if not prevent it from lasing altogether.

If a wafer has both lasers and detectors in an array, in order to AR coat only the detectors, conventional wisdom would mandate that special patterning of the wafer be performed to protect the lasers during the AR coating deposition phase to ensure that those laser devices were not covered by the AR coating.

The protection or disparate treatment of the various different devices on the wafer requires extra processing steps, which costs time, and hence increases the cost of processing. It also introduces the possibility of damaging the protected devices. Finally, it forces the electrical contact pads to be protected as well.

In addition disparate treatment of devices causes other processing problems when the processing must be performed on a chip having electrical contact pads in the same area. For example, if a chip has electrical contacts near the devices and electroplating, electroless plating, thermal evaporates, e-beam evaporated or sputtering techniques are used to place solder on the contact pads, the height of the resulting solder bumps, renders it difficult to pattern areas to protect lasers from AR coating because the solder bumps are much taller than the optical devices.

Prior art lacks a way to eliminate the need to pattern a protective layer over the lasers while allowing the entire wafer (i.e. lasers and detectors) to be AR coated.

Thus, there is a further need for a way to permit integration of multiple types of devices on an electronic chip so that any additional processing steps, such as anti-reflection coating, can be done on the whole wafer at one time and without special patterning after integration.

We create opto-electronic chips which, in some variants, provides one or more of the following advantages: allows use of a lower operating current, thereby reducing power consumption and heat generation; provides better dissipation of heat that is generated, allowing the lasers to run at lower temperatures thereby increasing their usable life and/or providing better wavelength control; and/or having a higher structural integrity resulting in fewer defects and increased device lifetime.

We have further devised a way to integrate optical and electronic chips to create an integrated opto-electronic device, irrespective of whether the component devices are manufactured in a coordinated manner or have compatibly matching electrical contact points.

Still further, we have devised a way to create an integrated opto-electronic device that allows for an entire wafer having disparate devices to be AR coated, without special processing to protect the lasers or affecting their ability to lase.

When integrating optical devices intimately with electronic chips, four attributes are desirable to create reliable integrated optical devices.

First, it must be possible to get optical fibers or optical lenses close enough to capture the light without crosstalk. Second, there must be no absorbing layers above the active region of the devices that would prevent light from escaping or entering the particular devices. Third, there should be a large enough thermal mass attached to the devices to allow for efficient heat dissipation. Fourth, the structural integrity of the devices should be maintained during processing so that stresses or strains experienced by the devices do not impact device performance.

As noted above, the approaches of FIG. 16 and FIG. 17 can satisfy the first two attributes however, neither of those approaches satisfies the third or fourth since neither approach results in a large thermal mass attached to the devices (i.e. the substrate of the devices) or reduces stresses on the devices.

Although applicants are unaware of any such case existing in the prior art or otherwise, the approach of FIG. 16 could potentially be made to satisfy the fourth attribute by leaving a thicker layer of substrate on the device. However, this could likely only be accomplished if the operating wavelength of the particular devices were very transparent to the wavelength at which the devices operated. Moreover, for many cases, this would reduce, if not destroy, the ability to satisfy the first attribute and would likely also detrimentally impact the operation of a laser device unless the laser were redesigned to emit into, for example, a semiconductor material rather than being designed to emit into air. In addition, if thicker substrates were left, it would be necessary to AR coat the structure to prevent optical feedback into the laser. In addition, such an approach would likely also foreclose the use of commercially purchasable prefabricated semiconductor optical devices, such as most third party offered Vertical Cavity Surface Emitting Lasers (VCSELs), Distributed Feed Back (DFB) lasers or Distributed Bragg Reflector (DBR) lasers.

In sum, we have devised a way to closely integrate optical devices and an electronic chip to create an opto-electronic chip that can satisfy all four attributes. Moreover we can do so using devices acquired from third parties when desired. Still further, we offer advantages over the prior art in terms of lower cost to produce, higher yield and improved operating life.

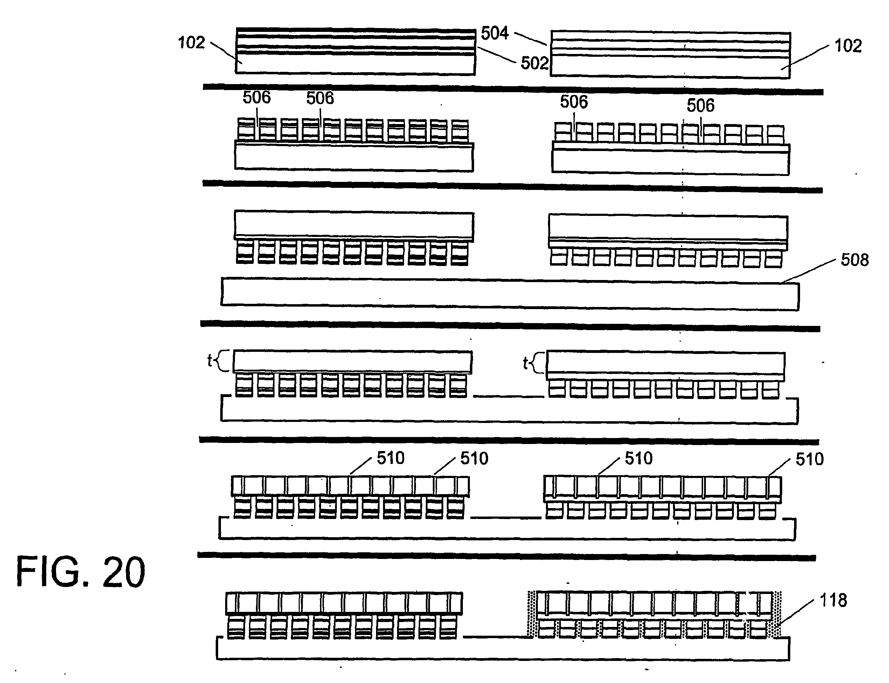

FIG. 20 shows, in simplified high level overview, one example approach according to the teachings of the invention. This approach overcomes shortcomings of the prior art while permitting close optical access, removing absorbing regions, providing a higher structural integrity, and having better thermal dissipation characteristics.

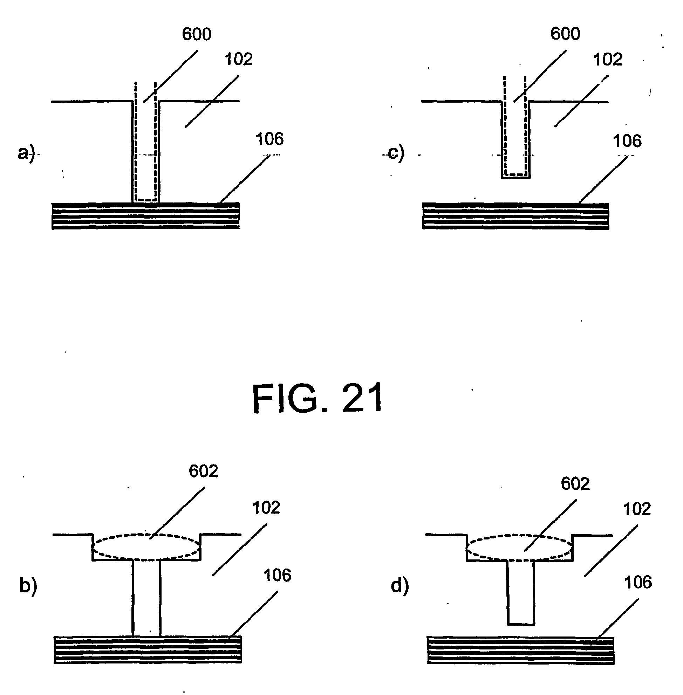

In the approach of FIG. 21, a laser wafer 20-502 (made up of lasers integrated with a substrate 20-102) and a detector wafer 20-504 (made up of detectors integrated with a substrate 20-102) is obtained, for example, by manufacturing them using a conventional technique or by purchase from an appropriate third party. Alternatively, a hybrid wafer made up of both lasers and detectors integrated with a common substrate, for example, in some alternating pattern or other grouping, is manufactured or obtained.

Trenches 20-506 are etched to process a wafer into individual devices (by etching into the substrate) or, in some cases, into appropriate groups of devices, for example, as shown in a commonly assigned application entitled Redundant Device Array filed concurrently herewith (and which is incorporated herein by reference) by etching into the substrate in some places while stopping the etch prior to it reaching the substrate in others.

Alternatively, since the invention is not the creation of the optical chip itself, per se (i.e, the creation of the wafer, growth of the devices, or etching to created discrete devices), the above would be skipped entirely if the optical device wafer was purchased instead of made.

The optical device wafer is then inverted and aligned over an electronic wafer 508 and bonded to the electronic wafer 20-508 using, for example, conventional flip-chip bonding techniques or some other appropriate proprietary technique that accomplishes bonding of the optical wafer to the electronic wafer in a suitable and reliable manner.

Alternatively, and advantageously in some cases, further processing of the substrate 20-102 can be accomplished, as described immediately below, either prior to bonding an optical wafer to the electronic wafer or after bonding, so long as it is done before cycling the devices over operational temperature extremes by device operation if done after. Such processing is unsuitable for the prior art techniques described above in connection with FIGS. 16 and 17 because, if used, it would dramatically increase the cost of producing devices by requiring individual bonding of each discrete device if the substrate were completely removed or dramatically reduce the yield, due to stress and/or strain problems when the substrate is very thin.

Depending upon the particular wafer(s) and optical devices used, different processing variants are now possible.

In a first variant, the substrate is thinned down to a thickness in excess of 50 microns, typically to within a range of between about 50 microns to about the 100 micron thickness typically required for close optical access.

In a second variant, the substrate is thinned to a thickness of between about 100 microns and about a thickness corresponding to the thickness of the optical device portion of the wafer.

In a third variant, the substrate is thinned to between about 20 microns and about 50 microns.

In a fourth variant, where the thickness of the substrate is about equal to the thickness of the optical device portion of the wafer, thinning is not required.

In a fifth variant, the substrate is thinned down to a thickness about equal to the thickness of the optical device portion of the wafer.

As will be apparent from the description below, in accordance with the invention, the thickness of the overall substrate could also be kept larger that the thickness necessary for close optical access, for example, where access ways are constructed (as described below) to allow for insertion of an optical fiber or microlens into the access way to a separation spacing from the device within the close optical access range. However, it is expected that such a case will be atypical.

An access way 20-510, in the form of a trench or hole is also etched or drilled in the substrate over the portion of an optical device where light is emitted or detected, for example, using conventional etching or drilling techniques, while preferably leaving some of the remaining substrate intact. Depending upon the particular substrate and device(s) different techniques can be used including laser drilling, etching or some combination thereof. In addition, depending upon the particular technique used, the access ways may have straight sidewalls, sloped sidewalls or some combination thereof.

For example, in order to produce an access way 20-510, having initially straight sidewalls near the substrate outer surface and sloped sidewalls near where the substrate meets the device, in a Gallium Arsinate (GaAs) substrate with an (Aluminum Gallium Arsinate) AlGaAs stop layer (supporting optical devices such as VCSELs and/or photodetectors (interchangeably referred to herein as detectors)) hybridized to an ASIC (collectively referred to as the "Sample"), the following approach can be used:

First, the access ways 20-510 are resist patterned on the substrate.

Then the sample is loaded into a 13.56 MHz parallel plate reactive ion etcher (RIE) and evacuated to a pressure below about 3X10⁻⁵ Torr before introduction of the precess gasses to reduce or eliminate residual water. Once this base pressure is reached, the first part of the etch is initiated at the process conditions of Table 1.

**Table 1**

| | |
|---|---|
| SiC14 | 14 sccm |
| SF6 | 7 sccm |
| Pressure | 20 mTorr |
| Chuck Temp. | 30°C |
| RF Power | 129 watts |
| Bias | -245 Vdc |
| Time | 5 min |

This produces a straight sidewall extending from the surface of the substrate into the substrate for a distance towards the device.

The process conditions are then optimized to produce the portion of the access ways 20-510 having sloped sidewalls with, in this example case, GaAs to AlGaAs selectivity near infinity with minimal device damage with the particular process conditions of Table 2.

**Table 2**

| | |
|---|---|
| SiC14 | 14 sccm |
| SF6 | 7 sccm |
| Pressure | 70 mTorr |
| Chuck Temp. | 30 °C |
| RF Power | 92 watts |
| Bias | -190 Vdc |
| Time | 30 min |

Then the process conditions are optimized to getter the residual Cl from the AlGaAs stoplayer. This is to prevent further formation of HCl (i.e. performing a wet etching) after the Sample is unloaded from the processing chamber. The process conditions for this portion of the process are set forth in Table 3.

**Table 3**

| | |
|---|---|
| SF6 | 7 sccm |
| Pressure | 70 mTorr |
| Chuck Temp. | 30 °C |
| RF Power | 50 watts |
| Bias | -20 Vdc |
| Time | 3 min |

In the simplest case, the access way will be as small as possible, so as to maximize the amount of substrate left on the device. The remaining substrate provides a rigid framework which prevents the individual devices from undergoing stresses, for example, during attachment to the electronic wafer. Depending upon the particular devices and substrate used however additional removal of substrate may further be performed, for example, at the time the access way is created, or by patterning the substrate at some point, for example, following attachment to the electronic wafer.

It should be noted however, that if removal of additional substrate is not properly planned, as more substrate is removed, the thermal dissipation advantage may be reduced or even eliminated. Moreover, depending upon how much, and/or from where, additional substrate is removed, the ability to withstand stress and strain may also be decreased. However, it can be appreciated, that, in some cases, by selective removal of substrate thermal dissipation can be improved by increasing the overall surface area of the substrate without sacrificing much, if any, of the structural advantages. Thus, it should be understood that the important aspect of the substrate removal is that sufficient substrate is left on the devices to ensure the desired thermal and structural characteristics are achieved.

Moreover, depending upon the particular technique used, provision of the access ways may advantageously be, in some cases, performed before or after bonding is performed, for example, before, after, or while the trenches separating the individual devices are etched.

Optionally, an AR coating can be applied to the detectors, if desired.

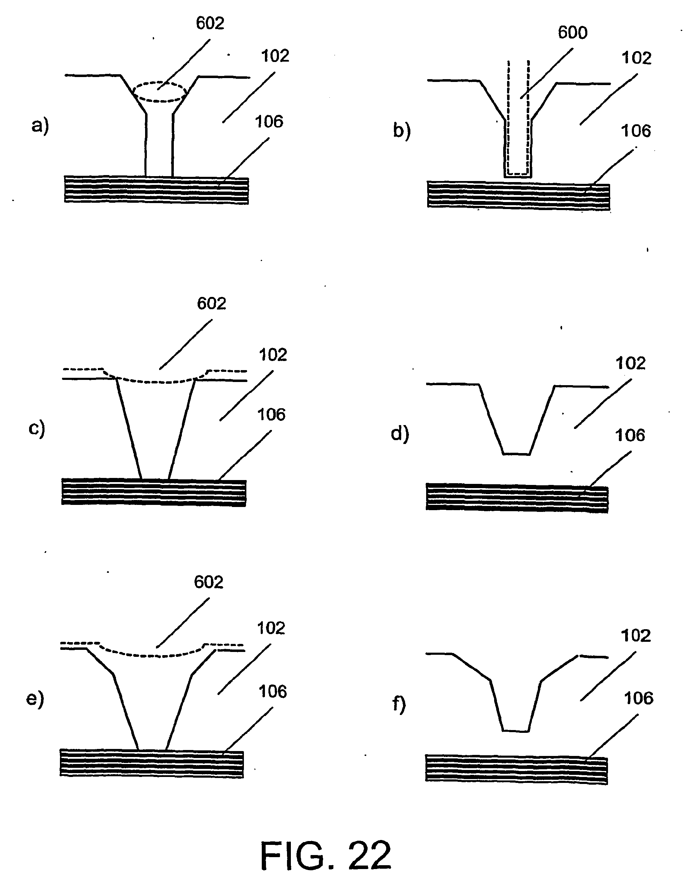

Depending upon which of the three immediately preceding variants above are used, different processing will occur. FIGS. 21 and 22 show several different accessways variant examples. For example, if the first variant was used, the access ways may extend entirely through the substrate (as shown in FIGS. 21a, 21b, 22a, 22c, 22e). Alternatively, they may extend from the outer surface of the substrate to a depth where the substrate remaining directly over the portion of an optical device where light is emitted or detected is reduced but not completely removed, for example, as shown in FIGS. 21c, 21d, 22b, 22d, 22f). In general, the substrate remaining directly over the portion of the optical device where light is emitted or detected will be reduced to a thickness of about 100 microns or less to enable close optical access to the device. In other cases, the thickness may be reduced to about 50 microns or less, and in some cases 20 microns or less, although typically the thickness will be within the range of about 20 microns to about 50 microns.

Additionally, depending upon the particular access way created, the access way may further be advantageously used to accommodate an optical fiber, for example, as shown in FIGS. 21a, 21c, 22b or a microlens, for example, as shown in FIGS. 21b, 21d, 22a, 22c.

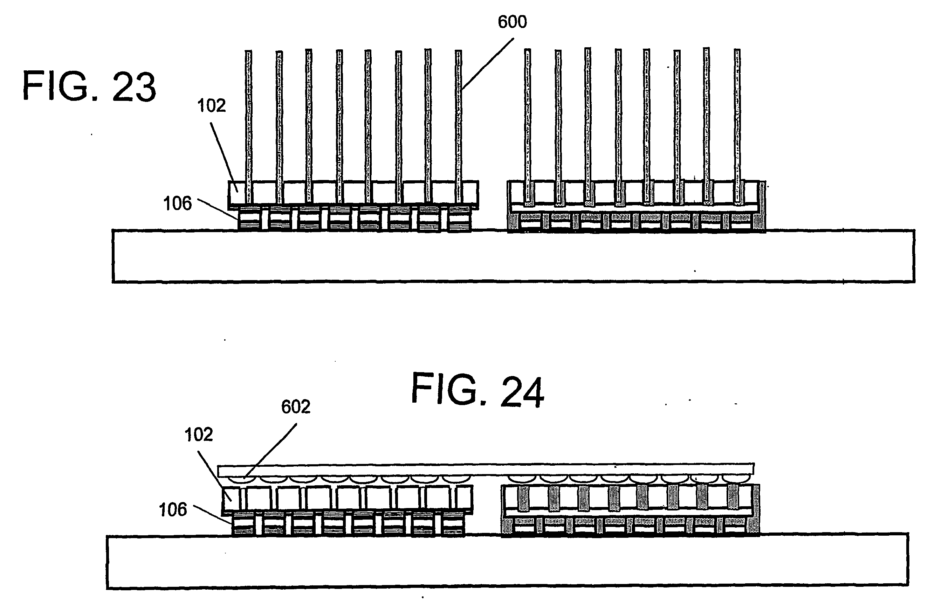

Thus, by employing one of the above approaches, an optical array in which ends of fibers are supported by the substrate can be created (such as shown in FIG. 14), an optical array that accommodates one or more individually placed microlenses supported by the substrate can be created (such as shown in FIGS. 21b, 21d, 22a, 22c, 22e), or an optical array that accommodates an array of microlenses can be created (such as shown in FIG. 24).

As noted above, the substrate can also be patterned to roughen the surface of the substrate and increase the exposed surface area for better thermal dissipation.

It should be appreciated that, by using the techniques described herein, i.e. leaving substrate attached, stresses will primarily not propagate to optical devices, but rather will be taken up by the connecting medium or the electronic chip, both of which are better able to withstand such stresses.

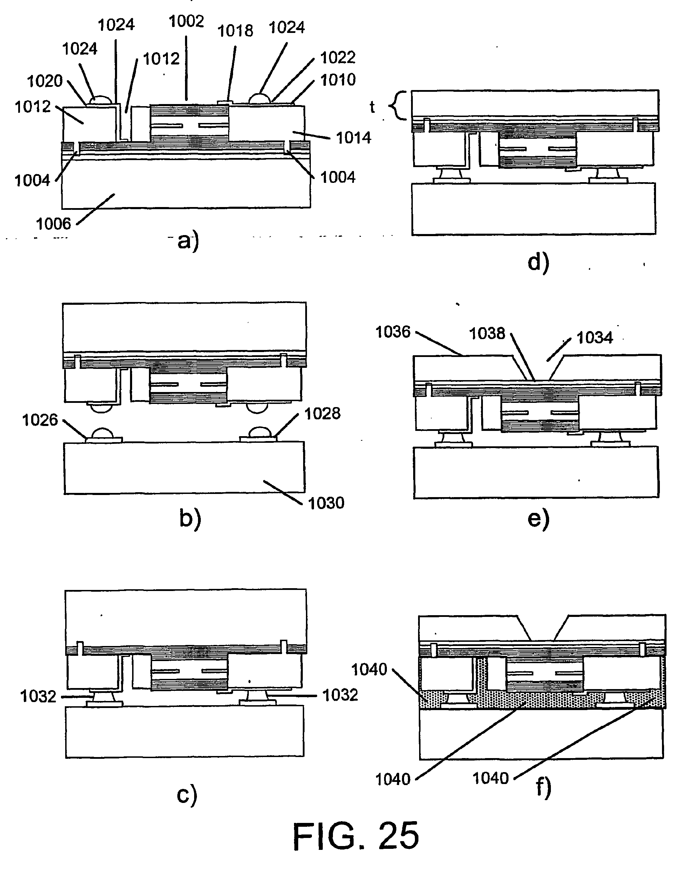

FIGS. 25-28 are each example illustrations of the process of creating electro-optical chip variants according to the techniques described above.

FIG. 25a is a simplified view of a single bottom surface emitting laser device 25-1002 that is part of an array of laser devices, the rest of which are not shown.

The device 25-1002 is isolated from its neighbors by isolating trenches 25-1004 and is supported on a substrate 25-1006 made of an appropriate material, for example, Silicon (Si), Silicon-Germanium (SiGe), Gallium-Arsenide (GaAs) or Indium-Phosphate (InP). Although the particular material used for the substrate will likely be determined by factors independent of the invention, it is worth noting that stresses due to thermal factors can be reduced by matching the coefficients of expansion of the optical device substrate and the electronic wafer as closely as possible. Ideally, the two should be of the same material, so that the coefficients of expansion of both are the same.

Electrical contacts 25-1008, 25-1010 used for laser excitation and control are each mounted on a stand 25-1012, 25-1014 for support. One end 25-1016, 25-1018 of each electrical contact acts as an electrode for the laser device and the other end of each is a pad 25-1020, 25-1022 onto which an electrically conductive material 25-1024, such as a solder, is deposited for bonding the device 25-1002 to an electronic wafer.

FIG. 25b shows the laser device 25-1002 of FIG. 25a after the laser array has been inverted and positioned over corresponding pads 25-1026, 25-1028 of an electronic wafer 25-1030.

FIG. 25c shows the laser device 25-1002 after it has been attached to the electronic wafer 25-1030 via a solder bond 25-1032 between the respective pads 25-1020, 25-1022, 25-1026,25-1028.

FIG. 25d shows the laser device after the substrate 25-1006 has been thinned to between about 20 microns and about 50 microns.

FIG. 25e shows the device after the access way 25-1034 has been created in the substrate 25-1006, in this case via etching instead of drilling. Note that in this example, the access way extends from the surface of the substrate 25-1036 to the device cladding layer 25-1038.

FIG. 25f shows the device of FIG. 25e after an optional thermally conductive material 25-1040 has been applied to the device such as, for example, a low viscosity (so it flows well for good coverage) thermal epoxy having good thermal conductivity when cured.

Although the above was illustrated with reference to a laser device, the process would be that same for a detector type device, except that the detector device may also be AR coated.

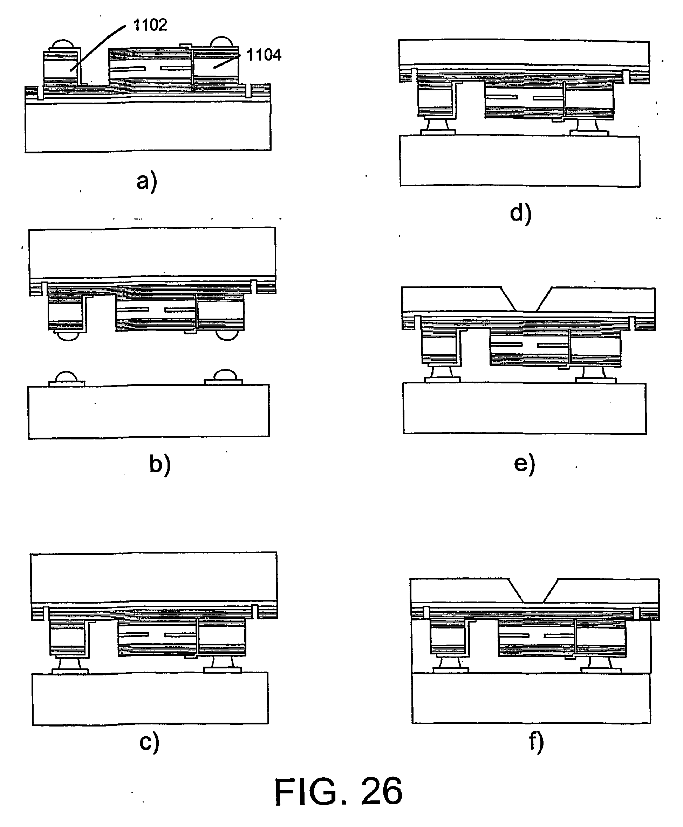

FIGS. 26a-26f show another opto-electronic device being created in a manner similar to the one shown in FIGS. 26a-26f except that this laser device uses the semiconductor material of the device as the stands 26-1102, 26-1104.

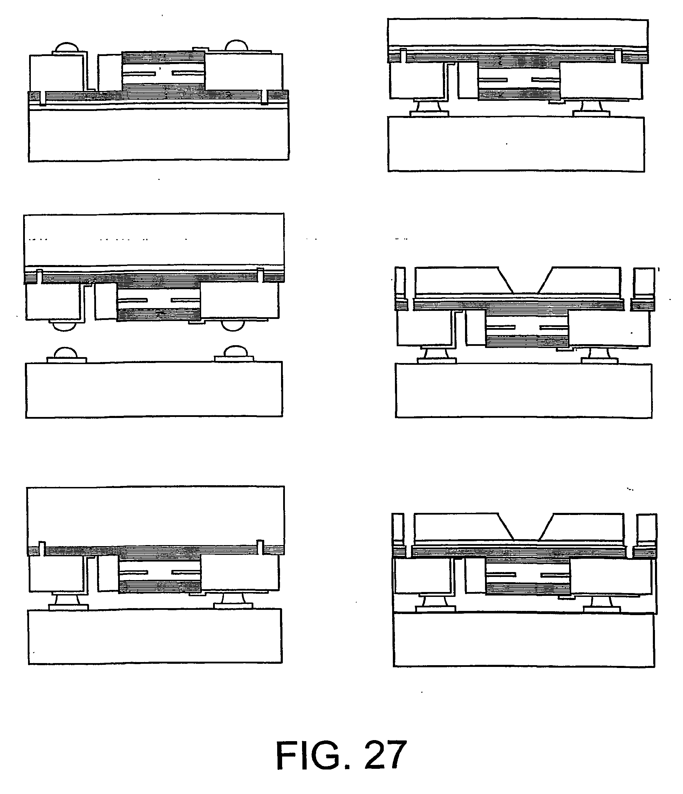

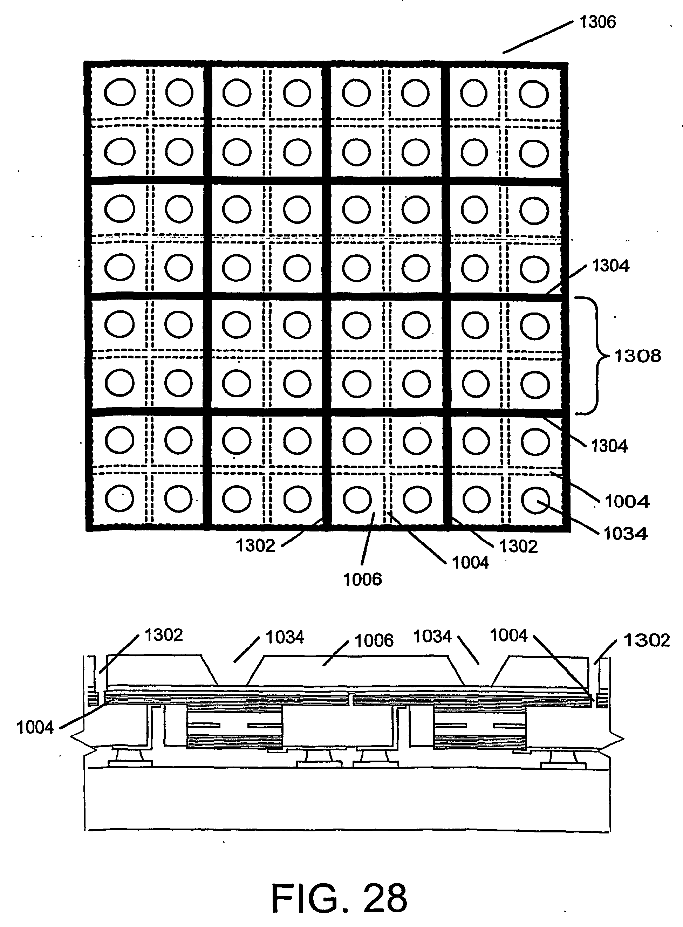

FIGS. 27a-27f show another opto-electronic device being created in a manner similar to the preceding devices. As shown, this device is of the type where the device semiconductor material is not used for the stands. Additionally, the lasers of this opto-electronic device are grouped so that they can be used in a redundant fashion. As noted above, the creation of an array having redundant lasers is described in the incorporated by reference patent application entitled Redundant Optical Device Array. Specifically, FIG. 28, shows two adjacent lasers in the array where, in addition to creating an access way 28-1034, grouping trenches 28-1302, 28-1304 are etched in the remaining substrate 28-1006 using known etching techniques, to a depth that connects the grouping trenches 28-1302, 28-1304 with some of the isolating trenches 28-1004. In this manner, two or more lasers can be arranged to share a common fiber with one or more serving as a back-up laser, such as described in commonly assigned application entitled Redundant Optical Device Array which is incorporated herein by reference.

One advantage arising from grouping the lasers in this manner is that yield for a single wafer is increased because, for example, with a pair of grouped lasers, if one laser is damaged, the other can be used in its place. Another potential advantage to doing so can be an increased lifetime for the opto-electronic device. For example, when one laser of the pair finally dies, if the lasers are externally, independently selectable, the second laser can be selected and brought on line in place of the bad one.

Yet another achievable advantage is reduced cost to achieve one or both of the immediately preceding two advantages. Since the incremental cost of increasing the number of lasers on a wafer is negligible, the improved yield and/or reliability/extended life is virtually free.

FIG. 28 also shows a functional representation of an example array 28-1306 produced using the technique of FIGS. 18a-18f. The array 28-1306 is illustrated from the top of the device so that the access way 28-1034 and remaining substrate 28-1006 over each laser is clearly visible. As shown in FIG. 28, the lasers are grouped in fours, a group 28-1308 being defined by the grouping trenches 28-1302, 28-1304 which ensure that there is no current path between adjacent lasers in the group 28-1308 via the substrate 28-1006 which is electrically conducting. For purposes of illustration, some of the isolating trenches 28-1004 are shown although none would actually be visible from this vantage point.

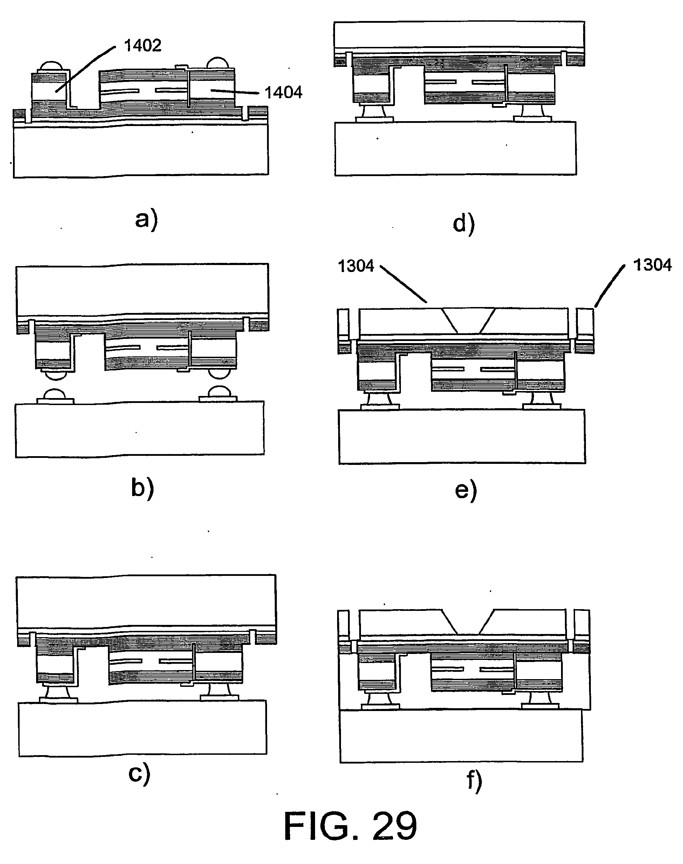

FIGS. 29a-29f, show another opto-electronic device being created in a manner similar to the devices of FIGS. 25 through 27. As shown, this device is of the type where the device semiconductor material is used for the stands 29-1402, 29-1404. Additionally, the lasers of this opto-electronic device are also grouped in the manner of FIGS. 27 and 28 except in pairs (one of which is not shown), as is evident from the grouping trenches.

As noted above, a manufacturer of opto-electronic devices of the type described above has two avenues for obtaining the optical devices - they can manufacture them themselves, or they can obtain them from a third party. By manufacturing the optical devices (referred to hereafter for simplicity as an "optical chip") and the electronic wafer (referred to hereafter for simplicity as an "electronic chip"), the manufacturer can take measures to ensure that the pads on each are properly placed so as to align with each other when the optical chip is positioned over the electronic chip. However, typically electrical and optical chips are not designed concurrently, even if they are designed and fabricated within the same organization. Thus, even with a single manufacturer, unless there is close coordination within the organization with regard to both the optical and electronic chip design, a lack of correspondence between contact pads on each can easily occur - particularly where one or both are also designed with sales to third parties or integration with devices from other sources is contemplated. Moreover, subsequent improvements or changes in the design of either may necessitate altering the location of the contact pads, thereby introducing a pad misalignment where none previously existed, even within the same organization.

Even worse, if the electronic chip is designed to be used with a variety of different optical chips, but the optical chips are commodity stock obtained from third parties (for example, chips containing: topside emitting cavity lasers, bottom emitting cavity lasers, DFB or DBR lasers, topside receiving detectors or bottom receiving detectors) that are mass manufactured for distribution to multiple unrelated users, it is unlikely that the pads on the optical devices will all be located in the same place, if they are otherwise compatible with the electronic chip.

For example, as shown above in connection with FIG. 18, a single optical device has contact pads placed in the position specified by its manufacturer and an electronic wafer also has contact pads, onto which an optical device can be connected, placed in the position specified by its manufacturer. When the optical device is flipped over, for flip-chip type bonding with the electronic wafer, the contact pads of each will not be aligned. Nevertheless, by altering the technique described above, the invention can be employed with lasers other than the bottom emitting lasers referred to in the examples up until now, as well as with bottom emitting lasers having different contact pad alignments, top or bottom receiving detectors.

Advantageously, this allows for the selection and use of the "best-of-breed" chips having the best individual performance for the application and avoids eliminating such vendors merely because they can not, or will not, meet an electrical contact placement requirement or standard.

In general, two different processes are used, depending upon whether the optical devices are bottom emitting/receiving or topside emitting/receiving.

For ease of explanation, the term "bottom active" will be used to refer to both bottom emitting devices (lasers) and bottom receiving devices (detectors). Similarly, "top active" or "topside active" will refer to both top emitting lasers and top receiving detectors.

### Bottom Active Device Process

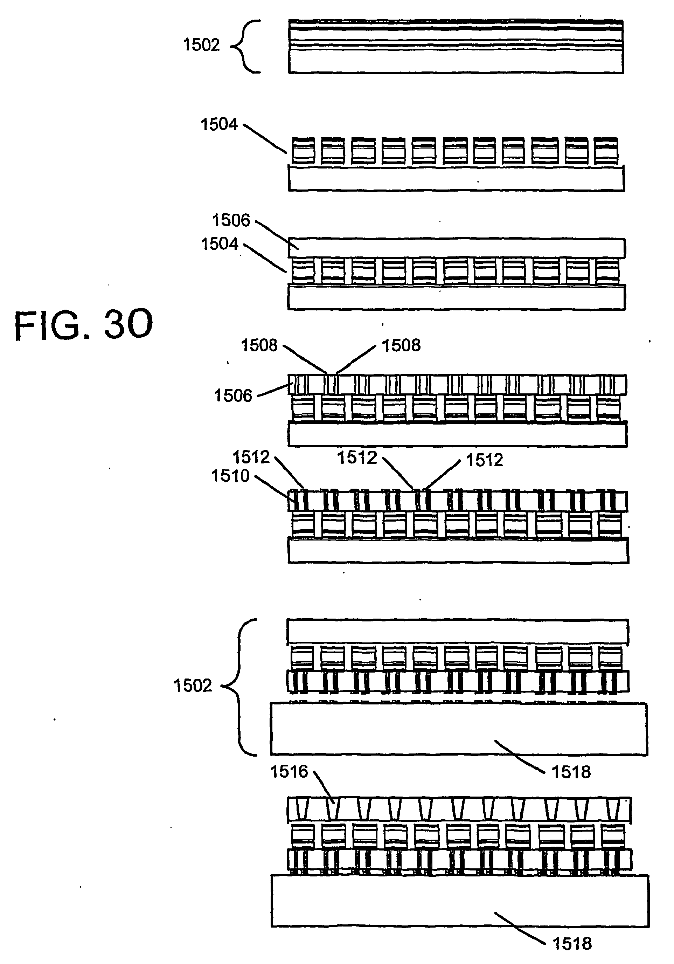

The process as usable for bottom emitting/receiving devices (i.e. bottom active devices) will now be explained, with reference to FIG. 30. To facilitate explanation, it should be presumed that the optical wafer 30-1502 was processed into an optical chip 30-1504 as discussed above. Alternatively, the optical chip 30-1504, can have been obtained from some third party.

First, an insulating layer 30-1506 is added to the surface of the optical chip 30-1504 using known techniques.

Then openings or vias 30-1508 are created in the insulating layer 30-1506 to allow access to the contact pads of the optical chip. This is again done by laser drilling or etching, for example in the manner used for creating through holes in wafers described below in the section entitled "Multi-Piece Fiber Optic Component And Manufacturing Technique".

Alternatively, the openings or vias 30-1508 can be pre-formed in the insulating layer prior to attachment, for example, if the contact pad locations are known in advance.

Then, the openings or vias 30-1508 are made electrically conductive by applying an electrically conductive material 30-1510 to the sidewalls of the openings or vias (which may optionally have been previously coated with an insulator) or filling the openings or vias with the material 30-1510.

Advantageously, if the openings or vias are not fully filled, they can be used to aid alignment. This can be done if the openings or vias are wide enough to allow the solder bumps on the other chip to "slot" into the holes, thereby providing an initial alignment between the two. Moreover, in some cases, capillary action will cause the solder to be partly drawn into the openings or vias as it melts causing a better connection and further aiding in alignment.

Optionally, and alternatively, if the openings or vias were pre-formed prior to attachment, the coating or filling of the openings or vias (as desired) can also be performed prior to attaching the insulating layer to the optical chip.

Next, electrical traces 30-1512 are patterned on the exposed side of the insulator to create a conductive path from the (now coated or filled) opening or via to the location(s) on the insulator surface that will align with the placement of the contact pads on the electrical wafer. Optionally, if several different alignments are possible, depending upon the particular electronic chip the optical chip will be mated with, a single trace can create two or more alternative connection points or create a connection region if the contacts to be mated with are offset from each other slightly, but within a manageable defined area.

In a variant of the above, if the chip to which the optical chip will be joined is an electronic chip (as opposed to another optical chip, such as a modulator, or another laser to which the optical chip is optically transparent) the electrical traces could be patterned on the electronic chip since, in general, most electronic chips already come with an insulating layer that can be used for contact rerouting.

Once this is accomplished, the process proceeds as described above, with the joining of the two chips 30-1514 (in this example, using flip-chip techniques) followed by, in the particular case, thinning of the substrate, removal of the substrate entirely, or leaving of the substrate at the thickness it is. Thereafter, creation of access ways 30-1516, patterning of the chip substrate, flowing of a thermal conductor, or application of AR coating can be accomplished as desired or needed.

### Topside Active Device Process

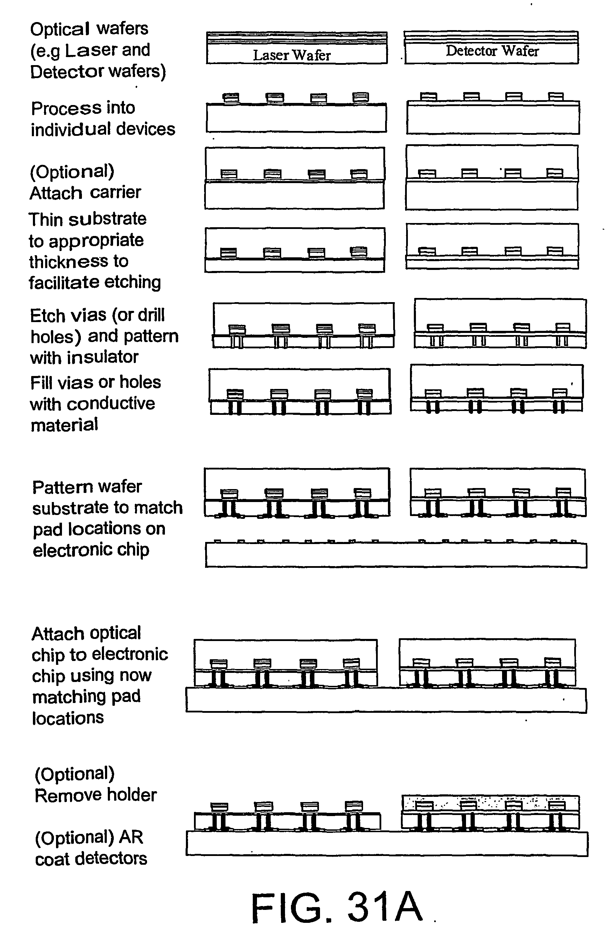

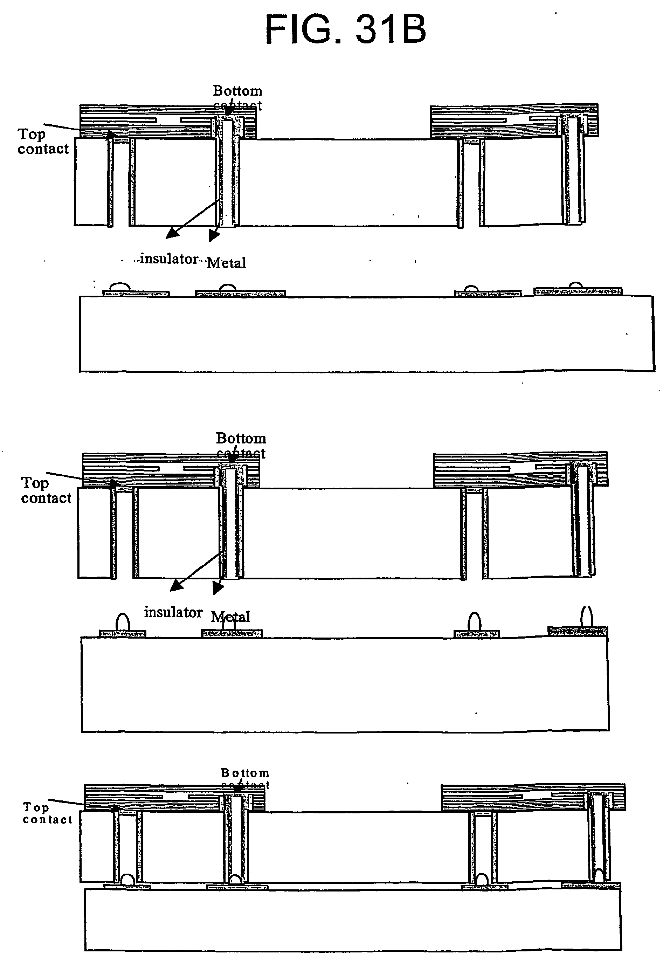

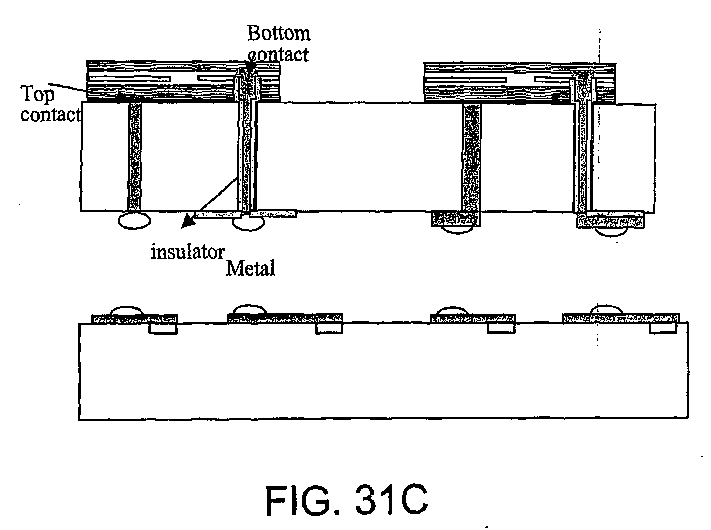

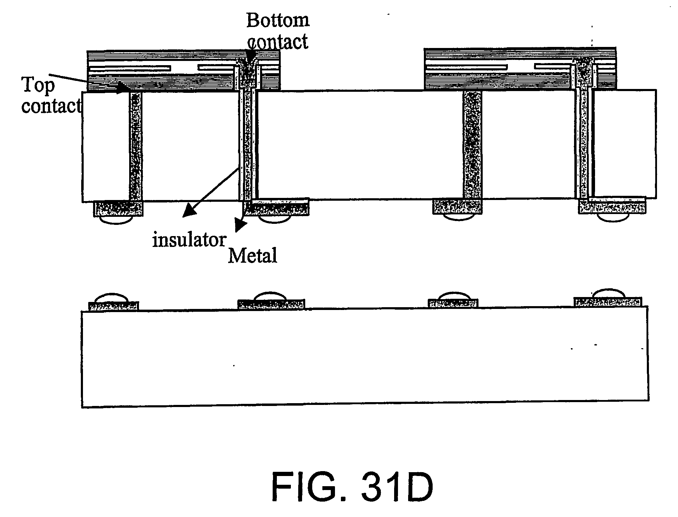

The process as usable for topside emitting/receiving devices (i.e. topside active devices) will now be explained, with reference to FIG. 31. To facilitate explanation, it should be presumed that the optical chip was obtained from some third party, the process of creating the optical chip itself being independent of the invention.

In addition, either or both of two optional steps can be performed prior to starting the process. The first, attaches a carrier by the top-side surface of the optical chip. This carrier can be made of any material and is merely used for rigidity and holding the optical chip during the rest of the processing. The second, involves thinning the optical chip substrate. This reduces the amount of material that must be etched or drilled through to access the contacts present on the front of the optical chip.

At this point, the process proceeds in an analogous manner to the process of FIG. 30 as follows.

Holes or vias are either etched or drilled through the optical chip substrate to the contacts on the front of the optical chip.

The holes or vias are then coated or filled with, an electrically conductive material (which may be under layered by an insulator coating) to bring the contacts out to the back of the optical chip.

Alternatively, for example, if the contacts are located such that access directly from the back of the chip through the substrate would damage the chip or present some other problem, the holes or vias are etched or drilled in a suitable location and an electrical conductor can be added to the front side to connect the contact pad with the conductor coating or filling the vias or holes.

Advantageously, if the openings or vias are not fully filled, they can be used to aid alignment. This can be done if the openings or vias are wide enough to allow the solder bumps on the other chip to "slot" into the holes (FIG. 31B), thereby providing an initial alignment between the two. Moreover, in some cases, capillary action will cause the solder to be partly drawn into the openings or vias as it melts causing a better connection and further aiding in alignment.
Or, if the vias or holes can be located so as to coincide with the proper location for aligned mating with the electronic chip, that can also be done, and the vias or holes can be connected to the contact pads on the front side using conventional techniques.

As with the backside emitting/receiving device integration process, if the vias or holes do not coincide with the contact pads of the electronic chip, electrical traces are patterned on the substrate of the optical wafer FIG. 31C or the other chip FIG. 31D, in this case the electronic chip, to provide a connection between the vias or holes and the contact locations on the other chip.

At this point, the chips can be brought together and connected as described above.

If the optional step of adding the carrier was performed, the carrier can now be removed. If the carrier is so thick as to cause optical access problems or has an incompatible complex refractive index which would adversely affect transmission of laser light through the carrier, it should be removed. In alternative variants, the carrier can be left on, even if it would cause optical access problems or has an incompatible complex refractive index, by patterning access ways or through holes in the carrier, preferably prior to attachment to the optical chip.

In addition, if desired, one or more additional optical elements, such as microlenses or waveguides, can be put on top of the carrier.

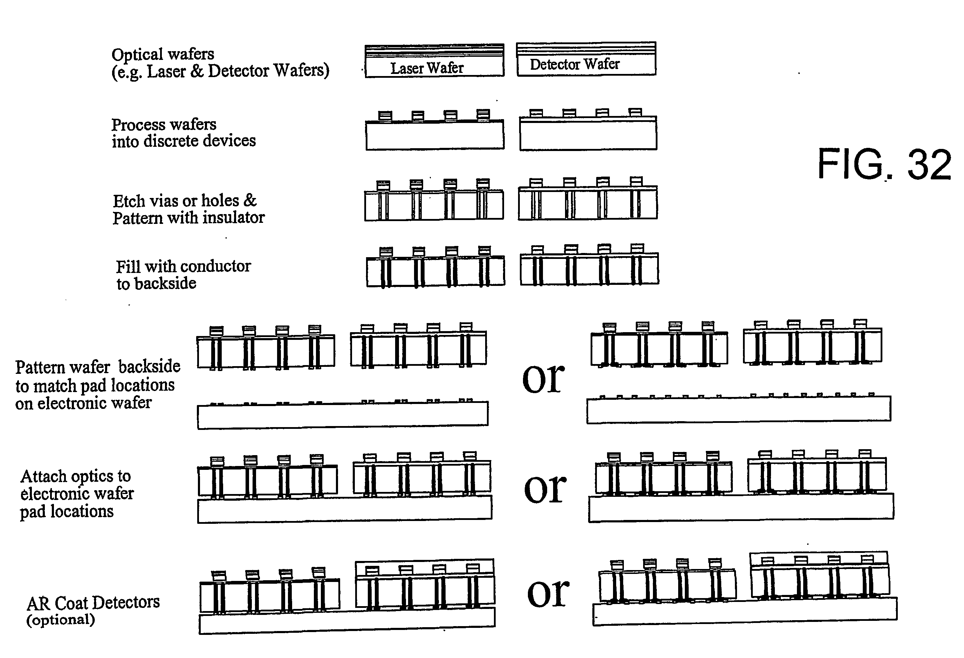

FIG. 32 shows a process similar to that shown in FIG. 31 except a carrier is not used.

### Connection or Adapter Chip Alternative

In an alternative variant usable, for example, when both the optical chip and the other chip are purchased from different parties or two or more different chips are under consideration and they have different contact pad placements, but the contact pad placement on each is known, an "adapter" or connection chip can be readily fabricated by employing the teachings herein in a straightforward manner, thus allowing design and/or manufacture to proceed nevertheless.

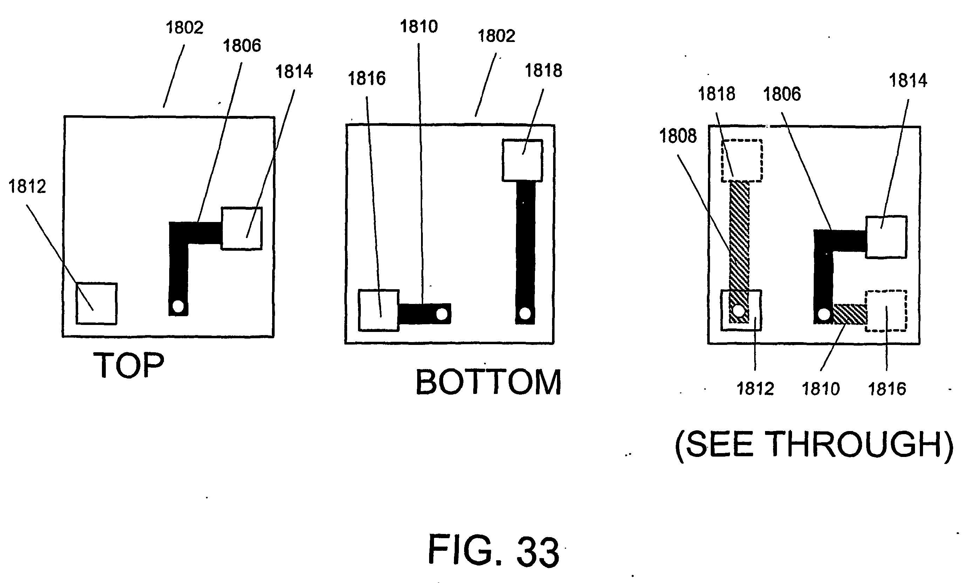

Referring now to FIG. 33 which shows a connection chip or adapter chip used to connect different devices, the top side 33-1802 and bottom side 33-1804 of a common wafer 33-1800 is patterned so as to create traces 33-1806, 33-1808, 33-1810 on each side from the specified contact pad locations 33-1812, 33-1814, 33-1816, 33-1818 for each chip to some common point for each.

Through holes are then created and crated or filled with a conductive material so as to join corresponding pairs, e.g., one contact on the top with its appropriate contact on the bottom when the two are brought together.

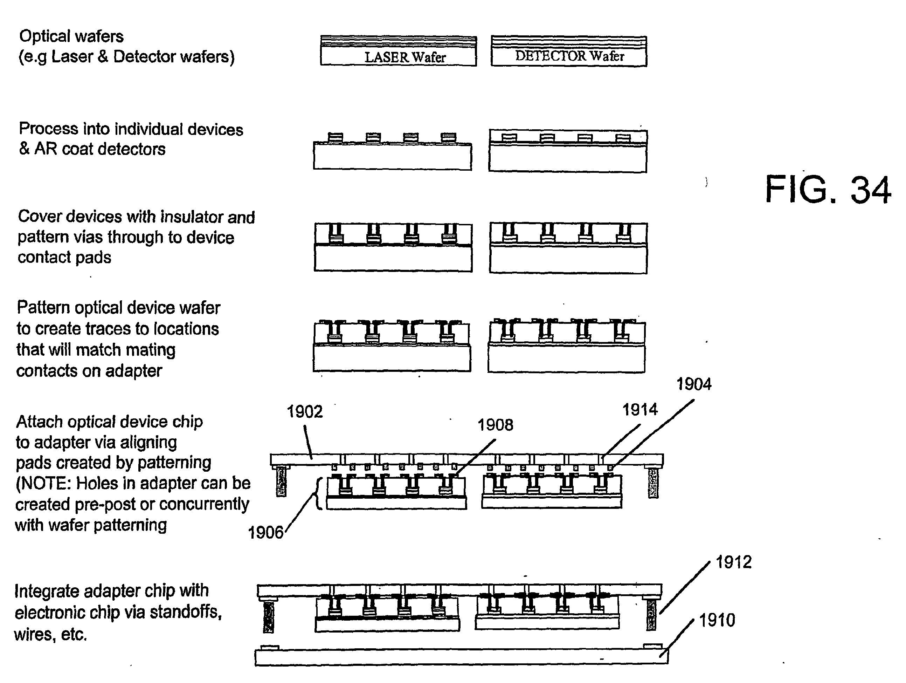

FIG. 34 shows another alternative implementation, which is a further variant of the adapter or connection chip variant, usable for topside active devices. As shown, the adapter or connection chip 34-1902 has electrical contacts 34-1904 on only one side for direct connection to the optical chip 34-1906 via connection pads 34-1908 and connection to the electronic chip 34-1910 via, for example, standoffs 34-1912, jumpers, wires, ribbons or other known attachment devices. In this arrangement, because the devices are top emitting/receiving and the adapter is located on the top side and, "optical vias" 34-1914 are also provided in the adapter to allow access to the optical light.

Then the optical chip can be placed on top of the electronic chip and the connection chip can be placed on top of both chips to provide connectivity between the optical and electronic chips.

As a side note, although described in connection with mating optical chips with electronic chips, the same basic process (i.e. use of a connection chip or appropriately patterned insulating layer or substrate to account for pad mismatch) can be adapted in a straightforward manner to account for a pad misalignment between any combination of optical, electrical, electronic, or electro-mechanical wafers.

### Further Variants

As also noted above, in some cases it is sometimes desirable to coat some of the devices, specifically the detectors, with an AR coating. However, the opto-electronic chips described above are made up of two (or potentially more) dissimilar types of optical devices. And it is undesirable to have the AR coating detrimentally affect the lasers.

Advantageously, in a further optional variant of the above processes, the devices that need to be AR coated do not have to be distinguished from those that ordinarily would not be AR coated.

The process largely follows the process flows described above in connection with FIG. 20 where the laser wafers and detector wafers are created, flipped over and attached to the electronic chip via flip-chip bonding techniques.

The substrates are thinned, but as to the laser substrate, only to the point where the substrate could still be considered thick relative to the thickness of the laser cavity. Although different types of laser devices will require a different specific thickness, the thickness of the substrate should be at least several times as large as the thickness of the laser cavity, in the case of DFBs and DBRs and the distance between the mirrors, in the case ofVCSELs. Since the precise distance will vary from device to device, a good rule of thumb is to use a factor of 10X the thickness of the laser cavity. However, if the thickness can be controlled precisely, it can be less than the 10X factor, the particular minimum thickness being empirically ascertainable as the minimum thickness where the AR coating does not affect the laser's ability to lase.

An analogous approach can be used for topside active lasers. In the case of topside active lasers, a substrate (which can be the carrier noted above, a separate substrate applied after carrier removal, or, if contact rerouting is not necessary or performed on the other chip, instead of a carrier) is attached to the topside of the lasers. The substrate is either thinned, after application, to a thickness as noted above, thinned to such thickness prior to application.

Once this is achieved, the lasers and detectors can be anti-reflection coated at the same time. Thus, there is no need for special patterning or otherwise distinguishing between the lasers and detectors during the AR coating process.

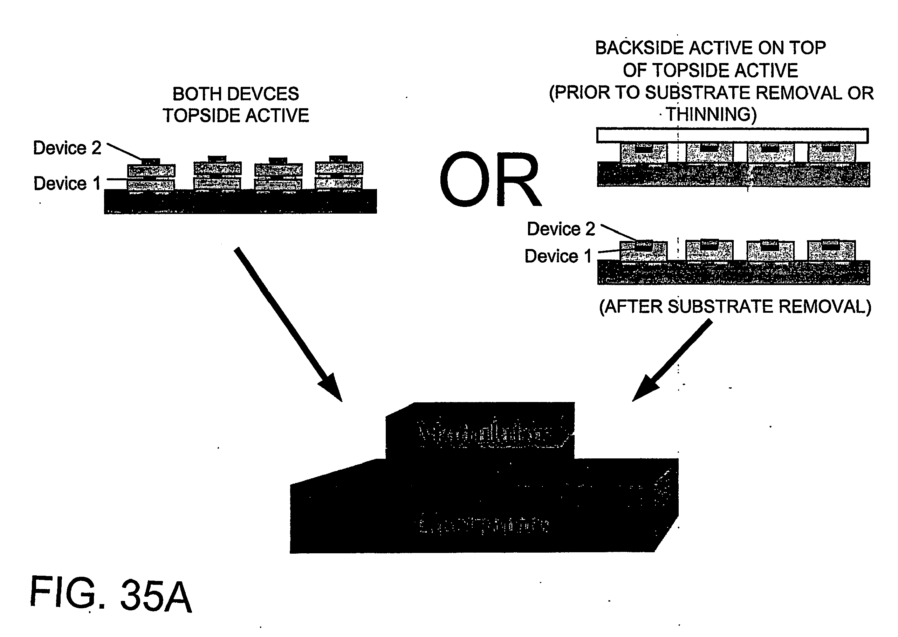

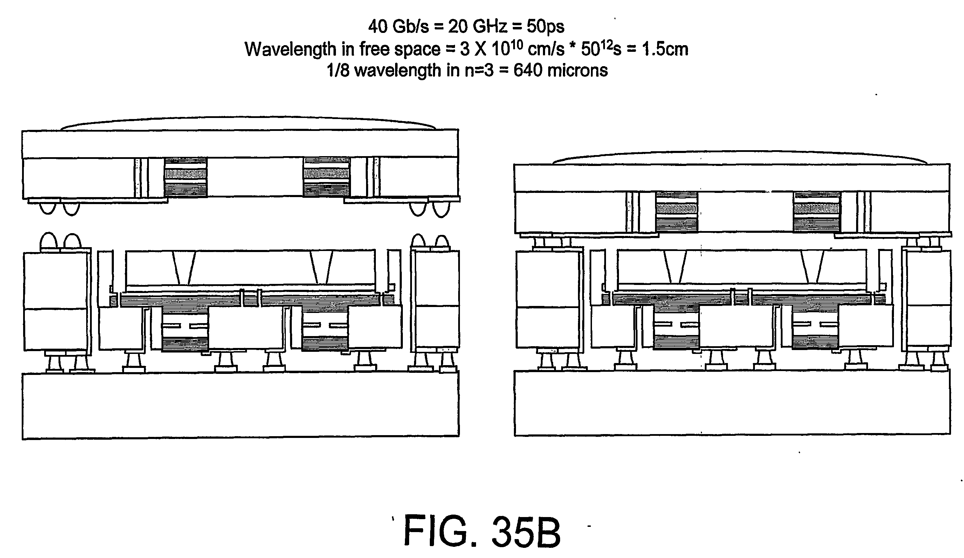

Thus, it should be understood that the above processes can be applied to various different devices. For example, using the teachings of the invention, stacking of modulators on top of lasers in an array compatible format can be done. In fact, it can be done when the modulators are on top of or below the laser. Moreover, it can be done whether or not the two (or more) devices are created in a single epitaxial step. Similarly, stacking of topside active devices on top of either topside or backside active devices can be performed as can stacking of backside active devices on top of either topside or backside active devices such as shown in FIGS. 35A and in greater detail in for modulator mounted on a backside emitting laser 35B.

Devices that have a lattice mismatch can similarly be stacked regardless of the functions the individual devices perform.

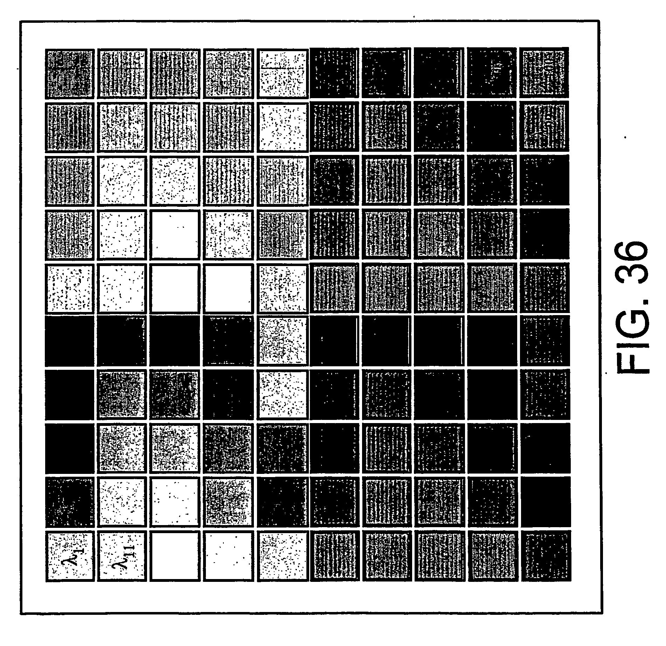

In a further application, devices from different epitaxial wafers can be integrated together on a common chip on a wafer scale level. Thus, lasers of different wavelengths can be intermixed for dual wavelength division multiplexing (DWDM) or multiple wavelength division multiplexing (MWDM) applications, such as shown in FIG. 36.

FIG. 36 shows an array of one hundred different wavelength lasers all integrated on a common chip on a wafer scale. By doing so, and making each laser selectable, a specific wavelength (or combination of wavelengths can be selected. Thereby eliminating the need for tunable lasers which rely on analog movements of physical pieces or show thermal changes or effects and where speed is limited to microseconds and accuracy is limited.

In addition, wavelengths can be switched at the same rate that data is sent, thereby making construction of a system that multiplexes various data streams at different wavelengths at the bit rate. Thus, switching can be achieved in about 100 picoseconds (10s of gigabits/sec).

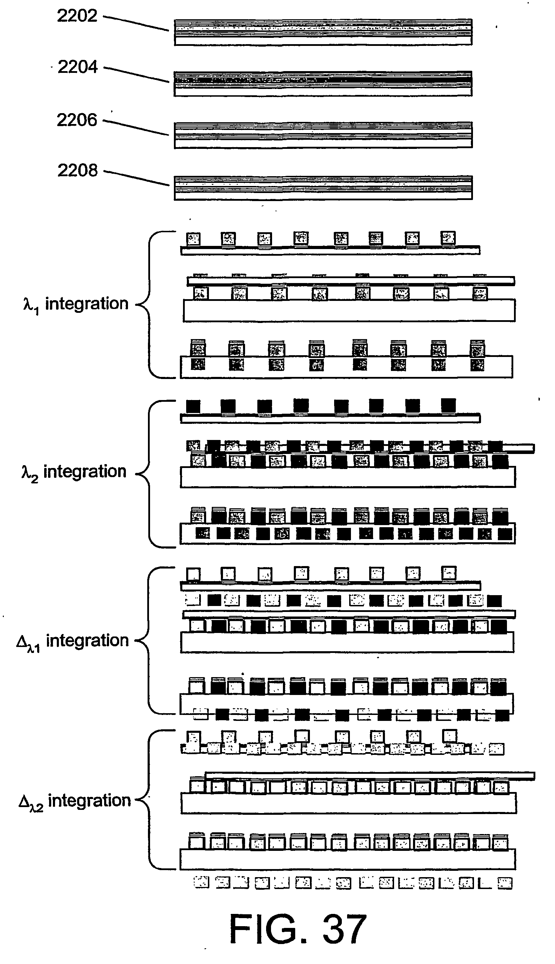

Moreover, different devices, of different types (i.e. different types of lasers, lasers and detectors, etc.) can be intermixed such as shown in FIG. 37 from a cutaway side view.

As shown in FIG. 37, strips of two different wavelength lasers 37-2202, 37-2206 are created, as are two different strips of complementary wavelength photodetectors 37-2204, 37-2208. The strips of the first devices (illustratively lasers 37-2202 (λ₁)) are attached using the processes described herein. The strips of the next devices (illustratively detectors 37-2204 (Δ_{λ1})) are attached in similar fashion. Next the strips of the third devices (illustratively lasers 37-2206 (λ₂)) are attached in similar fashion. Finally, the strips of the last devices (illustratively detectors 37-2208 (Δ_{λ2})) are attached in similar fashion.

Depending upon the particular case, the substrate or carrier can be removed or thinned from all the devices at once, for example if they did not interfere with the integration of the next devices, or they can be removed or thinned after each set of devices is attached.

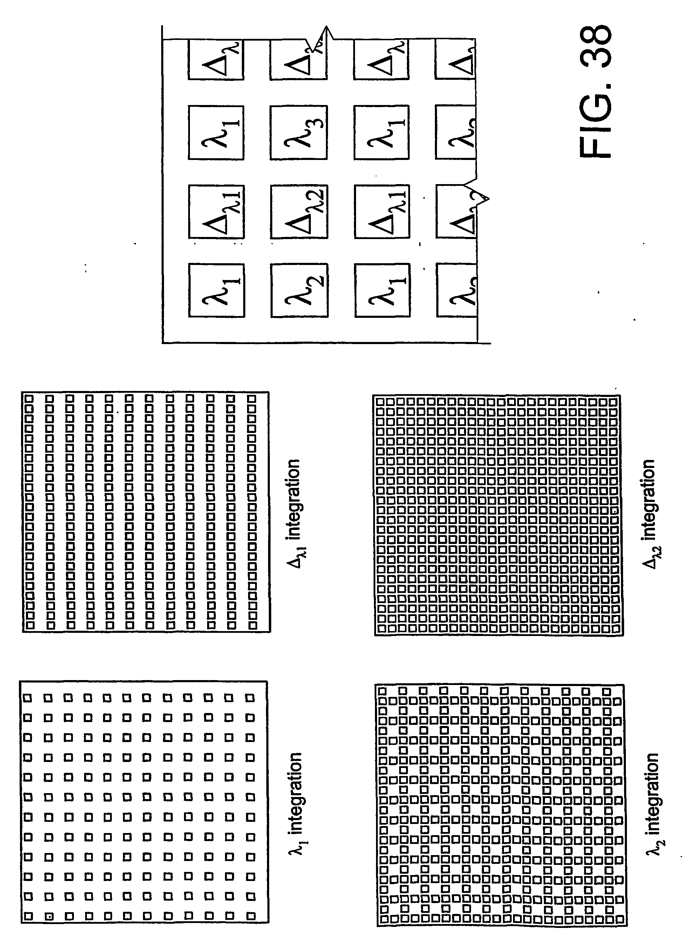

FIG. 38 shows the integration of the devices of FIG. 37 from a top view. As shown, all the first wavelength lasers are attached. Then, all the first wavelength photodetectors are attached. Then all the second wavelength lasers are attached, followed by all the second wavelength photodetectors so that the end result is a fully integrated dual wavelength transceiver chip, a portion of which is shown in enlarged form on the right side of FIG. 38.

Of course, while the immediately preceding example used two lasers and two detectors, the process would be essentially the same irrespective of the number of different devices, whether they are top or bottom active, grouped, all lasers, all detectors, etc., since an advantage of the process is the ability to mix and match - particularly on a wafer scale.

In these cases, the integration can readily be performed on an individual device (or device type) basis or can be done, for example, in strips (as shown) or by groups, with the substrate left on defining the strip 38-2202, 38-2204, 38-2206, 38-2208 or group.

Still further, by integrating groups of redundant lasers of one wavelength with those of other wavelengths, an extremely reliable DWDM or MWDM module can be produced at low cost.

Thus, since single device, integrated transmitter arrays for DWDM systems are not available in the prior art, by integrating large numbers of lasers on a single chip, packaging size can be reduced. By integrating arrays of ten or more lasers, of two or more different wavelengths, onto a single chip and coupling a set of them into a single fiber, for example, using a fiber based combiner/inverse splitter, a holographic lense array, or the techniques of the incorporated by reference applications entitled Multi-Piece Fiber Optic Component And Manufacturing Technique, the multiplexing of multiple wavelengths can be achieved in the output fiber, in some cases without the need for an opto-mechanical or electro-optical element to do the switching (optical crossconnect).

In a further application of the techniques, a large array can be constructed that can serve as both a pumping laser and a communications laser, either at different times or concurrently.

### Successive Integration Of Multiple Devices Process and Products

When electronic connections are made among the chips, packages and circuit boards that make up an opto-electronic module, wire bonds, which consist of short wires soldered to one or more of the chips, packages, and circuit boards, are typically used. Wire bonds are limited in their frequency response due to their long length and hence high capacitance and inductance.

Hence, using wire bonds to make high speed opto-electronic modules is undesirable.

In other cases, even if wire bonds are not used, modules are created based upon an "inside-to-outside" integration process whereby the innermost components (and those outer components that can be done in parallel) are combined, followed by integration of the combined components to each other or one or more circuit boards, etc. until the entire module is complete. Such a process is, most often, based upon the location of the components in the module and does not typically take into account the process whereby the overall module is created or the effect that integrating one component can have on another component (causing reduced life) or its connection (increasing capacitance and/or resistance). Thus, present techniques can result in a less reliable or lower performance product because integration of one component may weaken a connection, increase the capacitance and/or resistance of a connection, or increase the susceptibility to thermal and/or physical stresses of a connection, for an earlier integrated component.

Thus, even where wire bond connections are not used, the particular process used may nevertheless have an undesirable and adverse effect on the reliability and/or performance of the overall product ultimately produced.

We have developed a process that allows for creation of a module made up of a number of components, that does not connect components using wire bonds. We have further developed a process that does not cause the integration of later components to have an adverse effect on earlier integrated components. As a result, our process results in a product that will be more reliable than the identical product produced according to the processes in the prior art.

Specifically, by using a hierarchical attachment process, we have created a packaging technique that allows optical devices to be attached to electronic chips, electronic chips to be attached to packaging and packaging to be attached to printed circuit boards, all without wire bonds. This generally allows the highest frequency response connections possible (i.e. the speed is limited only by component capabilities, not the wiring among the components). In addition, it allows for a more reliable end product.

In overview, we have recognized that by using different solder materials, having different melting points and attachment temperatures, and employing a particular attachment sequence related to the attachment material being used, as opposed to the components being attached, the process does not have the problems present in the prior art. Moreover, our process is well suited to creation of non-optical electronic modules and particularly well suited to the creation of high performance opto-electronic modules where reduction of capacitance, inductance and resistance are of significant concern.

In accordance with the invention, we use a sequential process whereby at least:
1. one solder material, having a first melting point and a first attachment temperature, is used to attach the first group of components together, for example, optical device(s) to an electronic chip;
2. a second solder material, having a second melting point and second attachment temperature, is used to attach the previously joined components to another component, for example, one or more electronic chip(s) to a package; and
3. a third solder material, having a third melting point and third attachment temperature, is used to attach one or more of the components created in ii) to another component, for example, package(s) to a printed circuit board.

The process can be extended to four or more levels of attachment by straightforward material selection and extension of the process in the same manner as above.

The materials used in the three or more different attachment processes are specifically selected because they are thermally compatible. In other words, by way of example, the integration conditions for the chip to package connection is designed to not affect the optical component to chip connection performed prior to the chip to packaging attachment.

Specifically, the melting point of the solder for a given attachment is generally selected to be the higher than that of the melting points for the solders used in the successive steps in the process.

In other words, the solder for the first attachment step has the highest melting point. The solder for the second attachment step has a lower melting point than the solder used in the first attachment step. The solder for the third attachment step has a lower melting point than both of the solders used in the preceding two attachment steps. Depending upon the particular implementation, a fourth or more attachment steps may be involved.

If any step involves a thermally sensitive adhesive other than solder, the same procedure applies. That is, its melting temperature must also be such that heating the adhesive to its melting point will not result in the temperature exceeding the melting point of the materials used for all the preceding connections, as measured at the preceding connection points.

The same is typically, although not necessarily always, true for the attachment temperatures relative to each other, i.e. the attachment temperature for a given step will be higher than that the attachment temperature of the material used in any successive step.

In some variants, it is possible to use the same material and, accordingly, the same melting and attachment temperatures for all the steps provided that the temperature measured at the preceding connection points do not exceed the melting temperature.

Notably, in some cases, the attachment temperature in one step may be higher than the melting point of a preceding step. However, this is not a problem because, through use of an encapsulant or due to the spacing of the particular components involved, at the point(s) of contact, the previously joined components will not reach a high enough temperature to have an adverse effect.

Having described our process in a general manner, the process will now be described, by way of two examples. In the first example, an opto-electronic transceiver module product is created. The product is made up of several lasers (an optical chip) integrated with one electronic chip and several photodetectors (a second optical chip) integrated with another electronic chip. The two electronic chips are integrated into a package which is integrated onto an electronic circuit board.

The second example creates a similar transceiver, except that both the optical chips (i.e. lasers chip and photodetector chip) share a common electronic chip and an additional component that is used for alignment of fibers with the optical devices is attached to the electronic chip, by way of a thermally activated glue.

### Example 1

In this example, the part of the process, the combination of joining materials (i.e. solder metals), melting points and attachment temperatures are shown in Table 4.

**Table 4**

| **Process** | **Material** | **Material Melting Point** | **Attachment Temperature** |
|---|---|---|---|
| Attaching optical devices to electronic IC | 20% Au / 80% Sn | 280°C | 310°C |
| Attaching IC to packaging | 95% Sn / 5% Sb | 240°C | 270°C |
| Attaching packaging to printed circuit board | 63% Sn / 37% Pb | 180°C | 210°C |

In this example, the first part of process begins with the attachment of the optical devices to an integrated circuit (IC). This is done with a material that has the highest melting point (in the example Au 20% / Sn 80% with a melting point of 280 °C). The connection points to be joined are brought together and the temperature is raised above the melting point to cause the solder to melt. The joined components are then cooled to below the melting point so that the solder is fully set.

The integrated opto-electronic IC containing the lasers and the integrated opto-electronic IC containing the detectors are then attached to the IC packaging, to create an opto-electronic module package, using a solder with a melting point lower than the prior solder material's melting point. In this case, a Sn 95% / Sb 5% solder is used (melting temperature of 240 °C). The contacts on the laser IC and the detector IC are each brought together with their respective connection locations on the IC packaging. The components are then heated to a temperature above 240 °C, but less than 280 °C so the solder of the prior joint(s) do not remelt. The joined parts are then cooled to below the melting temperature of the solder to set the new joint(s).

The final part of the temperature sensitive bonding process involves the attachment of the module package(s) to a printed circuit board to create the module. This is done with a solder material which has a melting temperature lower than either of the previous two solders used. In this case, a Sn 63% / Pb 37% solder, with a melting temperature of 180 °C is used. The contacts on the parts to be joined are brought together and heated to a temperature between 180°C and 240 °C. The module is then cooled to below the melting temperature of the solder to set the new joint(s).

Thus, since each subsequent attachment involves a temperature below the temperature of all the prior attachments, the attachment does not interfere or disrupt the prior connections.

### Example 2

In this example, a similar process is used to create a similar transceiver, except that both the optical chips (i.e. lasers chip and photodetector chip) share a common electronic chip and an additional component that is used for alignment of fibers with the optical devices is attached to the electronic chip, by way of a thermally activated adhesive glue that is not electrically conductive and has a melting temperature of 230°C and a setting temperature of 230 °C. As a result, the process is altered so that attachment of the component requiring the adhesive is performed before the attachment of the module to the printed circuit board. The steps and materials involved in the process are shown in Table 5.

**Table 5**

| **Process** | **Material** | **Material Melting Point** | **Attachment Temperature** |
|---|---|---|---|
| Attaching optical ICs to electronic IC | 20% Au / 80% Sn | 280°C | 310°C |
| Attaching IC to packaging | 95% Sn / 5% Sb | 240°C | 260°C |
| Attaching alignment piece to packaging | Thermal Glue | 230°C | 230°C |
| Attaching packaging to printed circuit board | 63% Sn / 37% Pb | 180°C | 210°C |

The process proceeds as above. First the optical ICs are both connected to the electronic IC. Next, the opto-electronic IC is attached to the packaging by melting the solder above 240 °C but below 280 °C. Then the alignment piece is bonded to the packaging using a temperature between 230 °C and 240 °C. Finally, the packaging is attached to the printed circuit board using a temperature between 180 °C and 230 °C.

It is well known that numerous different solders exist, from pure gold to alloys and eutectics of metals such as silver, lead, tin, antimony, bismuth, or other metals. Table 6 shows just a few of the many solders currently commercially available along with their respective approximate melting points.

**Table 6**

| **Solder Material** | **Melting Temp. (°C)** |
|---|---|
| 81.%Au/19%In | 487 |
| 96.85%Au/3.15%Si | 363 |
| 88%Au/12%Ge | 361 |
| 100%Pb | 327 |
| 95%Pb/5%In | 314 |
| 95%Pb/5%Sn | 314 |
| 5%Ag/90%Pb/5%In | 310 |
| 1.5%Ag/97.5%Pb/1%Sn | 309 |
| 78%Au/22%Sn | 305 |
| 2.5%Ag/95.5%Pb/2%Sn | 304 |
| 2.5%Ag/97.5%Pb | 303 |
| 90%Pb/10%Sn | 302 |
| 2.5%Ag/92.5%Pb/5%In | 300 |
| 2.5%Ag/92.5%Pb/5%Sn | 296 |
| 95%Pb/5%Sb | 295 |
| 5%Ag/90%Pb/5%Sn | 292 |
| 2%Ag/88%Pb/10%Sn | 290 |
| 85%Pb/15%Sn | 288 |
| 86%Pb/8%Bi/4%Sn/l%In/l%Ag | 286 |
| 80%Au/20%Sn | 280 |
| 80%Pb/20%Sn | 280 |
| 81%Pb/19%In | 280 |
| 75%Pb125%In | 264 |
| 70%Pb/30%Sn | 257 |
| 63.2%Pb/35%Sn/1.8%In | 243 |
| 95%Sn/5%Sb | 240 |
| 60%Pb/40%Sn | 238 |
| 97%Sn/3%Sb | 238 |
| 99%Sn/l%Sb | 235 |
| 100%Sn | 232 |
| 2.5%Ag/97.5%Sn | 226 |
| 3.5%Ag/95%Sn/1.5%Sb | 226 |
| 60%Pb/40%In | 225 |
| 3.5%Ag/96.5%Sn | 221 |
| 10%Au/90%Sn | 217 |
| 95.5%Sn/3.9%Ag/0.6%Cu | 217 |
| 96.2%Sn/2.5%Ag/0.8%Cu/0.5%Sb | 217 |
| 10%Pb/90%Sn | 213 |
| 50%Pb/50%Sn | 212 |
| 50%Pb/50%In | 209 |
| 15%Pb/85%Sn | 205 |
| 45%Pb/55%Sn | 200 |
| 20%Pb/80%Sn | 199 |
| 91%Sn/9%Zn | 199 |
| 40%Pb/60%Sn | 188 |
| 2.8%Ag/77.2%Sn/20%In | 187 |
| 89%Sn/8%Zn/3%Bi | 187 |
| 30%Pb/70%Sn | 186 |
| 40%Pb/60%In | 185 |
| 37%Pb/63%Sn | 183 |
| 37.5%Pb/37.5%Sn/25%In | 181 |
| 2%Ag/36%Pb/62%Sn | 179 |
| 30%Pb/70%In | 174 |
| 100%In | 157 |
| 5%Ag/15%Pb/80%In | 149 |
| 58%Sn/42%In | 145 |
| 3%Ag/97%In | 143 |
| 42%Sn/58%Bi | 139 |
| 48%Sn/52%In | 118 |
| 30%Pb/18%Sn/52%Bi | 96 |

Similarly, thermally activated adhesives that are non-electrically conductive exist and can be used in conjunction with the solders noted above according to the technique described herein.

Moreover, it should be further understood that the melting point of a material used for a particular step can be higher than one used in a preceding step provided that temperature at the prior connection point(s) stays below the melting point of its connection material. For example, with reference to Example 1 above, if the opto-electronic IC is coated with an encapsulent that will thermally insulate the opto-electronic IC to some extent, it may be possible to raise the temperature to above the temperature of the melting point of the material bonding the optical IC to the electronic IC because the temperature at the point of connection will not exceed the melting point due to the encapsulent. Additionally, or alternatively, if the components to be joined are sufficiently separated by space or a thermal shield or heat sink, as long as the melting temperature at the prior connection points is not exceeded that temperature can be exceeded at the new connection point. Thus, in Example 2, if a thermal shield was placed between the previously bonded components and the alignment piece or it was sufficiently spaced apart from the previous connections, the local temperature at the alignment piece connection point could exceed 240°C provided the temperature at the prior connection points did not exceed 240 °C.

Even restricting the combinations to the solders of Table 6, it will be recognized that the various specific potential combinations are too numerous to list. It should be understood that the use of different combinations of materials (such as, for example, appropriate solders selected from those listed in Table 6 and/or identified herein) according to the technique described herein will straightforwardly result in numerous variants in accordance with the invention. The important aspect not being the particular materials, but rather the relationship among the melting points of the materials used for each successive step in the process. In other words, as long as the solder materials are suitable for the particular purpose and the various components are joined in successive steps, where each successive connection involves a solder that can be melted without exceeding the melting temperature at the prior connection points, the process will work.

Finally, it should be recognized that the above referenced process need not be used for all the components of a particular assembly. For example, based upon example 1, the opto-electronic transceiver may be one part of an assembly that further includes a housing, one or more fans, connectors, cables, etc. Similarly, a particular assembly may be manufactured of multiple modules, some of which were created using the process described herein, for example that of example 2, and others which were manufactured using a prior art process, or have a module created according to one variant of the process (i.e. three specific materials) and another module created according to another variant of the process (i.e. at least one of the materials differs from the specific materials used in the first module).

It should be understood that the above description is only representative of illustrative embodiments. For the convenience of the reader, the above description has focused on a representative sample of all possible embodiments, a sample that teaches the principles of the invention. The description has not attempted to exhaustively enumerate all possible variations. That alternate embodiments may not have been presented for a specific portion of the invention, or that further undescribed alternate embodiments may be available for a portion, is not to be considered a disclaimer of those alternate embodiments. One of ordinary skill will appreciate that many of those undescribed embodiments incorporate the same principles of the invention and others are equivalent.

## Claims

1. A unit comprising:
an array of lasers (102, 210, 402, 404), drive electronics (104, 212, 412) and an array of modulators (100, 200, 300, 400) all integrated together in a stack so as to form a structural unit;
wherein the array of lasers (102, 210, 402, 404) have an emission surface through which beams can be emitted in a substantially vertical direction so as to define an emission side;
the drive electronics (104, 212, 412) are connected to a side opposite to the emission side of the array of lasers; and
the array of modulators (100, 200, 300, 400) are located on the emission side of the array of lasers and directly connected to the drive electronics via an electrical connection (206, 208, 416) that passes through the array of lasers.

2. The unit of claim 1 wherein the array of lasers is an array of vertical cavity surface emitting lasers (VCSELs).

3. The unit of claim 1 wherein the array of lasers is an array of distributed feedback (DFB) lasers.

4. The unit of claim 1, wherein the array of lasers is an array of distributed Bragg reflector (DBR) lasers.

5. The unit of any one of claims 2 to 4, wherein the lasers are top emitting or bottom emitting lasers.

6. The unit of claim 3 or 4, wherein the lasers further comprise elements that cause the lasers to emit perpendicular to a wafer plane of the lasers.

7. The unit of claim 6 wherein the elements are gratings that cause the lasers to top emit or to bottom emit.

8. The unit of claim 6 wherein the elements are micromirrors that cause the laser to top emit or to bottom emit.

9. The unit of claim 1 wherein at least some of the modulators are configured for external modulation of the beams.

10. The unit of claim 1 wherein at least some of the modulators are configured as detectors.

## Patentansprüche

1. Einheit, umfassend:
eine Anordnung von Lasern (102, 210, 402, 404), Treiberelektronikteile (104, 212, 412) und eine Anordnung von Modulatoren (100, 200, 300, 400), die alle zusammen in einem Stapel integriert sind, um eine konstruktive Einheit zu bilden;
wobei die Anordnung von Lasern (102, 210, 402, 404) eine Emissionsoberfläche aufweisen, durch die hindurch Strahlen in einer im Wesentlichen vertikalen Richtung emittiert werden können, um eine Emissionsseite zu definieren;
wobei die Treiberelektronikteile (104, 212, 412) mit einer der Emissionsseite der Anordnung von Lasern entgegengesetzten Seite verbunden sind; und
wobei die Anordnung von Modulatoren (100, 200, 300, 400) auf der Emissionsseite der Anordnung von Lasern liegen und über eine elektrische Verbindung (206, 208, 416), die durch die Anordnung von Lasern hindurchgeht, direkt mit den Treiberetektronikteilen verbunden sind,

2. Einheit nach Anspruch 1, bei der die Anordnung von Lasern eine Anordnung von Vertikalhohlraum-Oberflächenemissionslasern (VCSELs) ist.

3. Einheit nach Anspruch 1, bei der die Anordnung von Lasern eine Anordnung von Lasern mit verteilter Rückkopplung (DFB) ist.

4. Einheit nach Anspruch 1, bei der die Anordnung von Lasern eine Anordnung von Lasern mit verteilten Bragg-Reflektoren (DBR) ist.

5. Einheit nach einem der Ansprüche 2 bis 4, bei der die Laser oben emittierende oder unten emittierende Laser sind.

6. Einheit nach Anspruch 3 oder 4, bei der die Laser weiterhin Elemente umfassen, die bewirken, dass die Laser senkrecht zu einer Wafer-Ebene der Laser emittieren.

7. Einheit nach Anspruch 6, bei der die Elemente Gitter sind, die bewirken, dass die Laser oben emittieren oder unten emittieren.

8. Einheit nach Anspruch 6, bei der die Elemente Mikrospiegel sind, die bewirken, dass die Laser oben emittieren oder unten emittieren.

9. Einheit nach Anspruch 1, bei der mindestens einige der Modulatoren für externe Modulation der Strahlen konfiguriert sind.

10. Einheit nach Anspruch 1, bei der mindestens einige der Modulatoren als Detektoren konfiguriert sind.

## Revendications

1. Unité comprenant :
un groupement de lasers (102, 210, 402, 404), des circuits électroniques d'attaque (104, 212, 412) et un groupement de modulateurs (100, 200, 300, 400) tous intégrés ensemble dans un empilement de façon à former une unité structurelle ;
dans lequel le groupement de lasers (102, 210, 402, 404) comporte une surface d'émission à travers laquelle des faisceaux peuvent être émis dans une direction sensiblement verticale de façon à définir un côté d'émission ;
les circuits électroniques d'attaque (104, 212, 412) sont connectés à un côté opposé au côté d'émission du groupement de lasers ; et
le groupement de modulateurs (100, 200, 300, 400) est situé sur le côté d'émission du groupement de lasers et directement connecté aux circuits électroniques d'attaque par l'intermédiaire d'une connexion électrique (206, 208, 416) qui passe à travers le groupement de lasers.

2. Unité selon la revendication 1, dans laquelle le groupement de lasers est un groupement de lasers à émission de surface à cavité verticale (vertical cavity surface emitting lasers ou VCSEL).

3. Unité selon la revendication 1, dans laquelle le groupement de lasers est un groupement de lasers à rétroaction répartie (distributed feedback ou DFB).

4. Unité selon la revendication 1, dans laquelle le groupement de lasers est un groupement de lasers à réflecteurs de Bragg répartis (distributed Bragg reflector ou DBR).

5. Unité selon l'une quelconque des revendications 2 à 4, dans laquelle les lasers sont des lasers à émission par le dessus ou à émission par le dessous.

6. Unité selon la revendication 3 ou 4, dans laquelle les lasers comprennent de plus des éléments qui font émettre les lasers perpendiculairement à un plan de plaquette des lasers.

7. Unité selon la revendication 6, dans laquelle les éléments sont des réseaux de diffraction qui font émettre les lasers par le dessus ou qui leur font émettre par le dessous.

8. Unité selon la revendication 6, dans laquelle les éléments sont des micro-miroirs qui font émettre le laser par le dessus ou qui lui font émettre par le dessous.

9. Unité selon la revendication 1, dans laquelle au moins certains des modulateurs sont configurés pour une modulation externe des faisceaux.

10. Unité selon la revendication 1, dans laquelle au moins certains des modulateurs sont configurés sous la forme de détecteurs.
